# FASCICULE DE BREVET EUROPEEN

(11) **EP 4 507 005 B1**
(45) Date de publication et mention de la délivrance du brevet: **01.04.2026**
(21) Numéro de dépôt: 24193485.0
(22) Date de dépôt: 08.08.2024
(51) Int. Cl.: H10D 30/47, H10D 30/67, H10D 62/10, H10D 62/80, H10D 64/23, H10D 84/02, H10D 84/85, H10D 88/00, B82Y 10/00, B82Y 40/00

(54) **PROCÉDÉ DE RÉALISATION D'UN DISPOSITIF À TRANSISTORS SUPERPOSÉS**
VERFAHREN ZUR HERSTELLUNG EINER VORRICHTUNG MIT ÜBEREINANDERLIEGENDEN TRANSISTOREN
METHOD OF MANUFACTURING A DEVICE WITH STACKED TRANSISTORS

(30) Priorité: 11.08.2023 FR 2308688
(43) Date de publication de la demande: 12.02.2025
(73) Titulaire: Commissariat à l'Energie Atomique et aux Energies Alternatives, 75015 Paris (FR)
(72) Inventeur: BARRAUD, Sylvain, 38054 Grenoble Cedex 09 (FR)
(74) Mandataire: Hautier IP

(56) Documents cités:
- CN-A- 116 435 305
- FR-A1- 3 090 998
- US-A1- 2020 295 127
- US-A1- 2021 135 015
- US-A1- 2023 088 101
- US-B1- 10 388 732

## Description

### DOMAINE TECHNIQUE

L'invention concerne le domaine des technologies de la microélectronique. Elle trouve pour application particulièrement avantageuse la fabrication de dispositifs avancés de type CFET (« Complementary Field-Effect Transistors » en anglais, ou transistors à effet de champ complémentaires) comprenant deux transistors co-intégrés, de type N et de type P, à grille enrobante.

### ETAT DE LA TECHNIQUE

L'évolution de l'architecture des transistors, a joué un rôle crucial dans l'amélioration constante des performances des dispositifs microélectroniques et leur miniaturisation continue.

L'architecture MOSFET (« Metal-Oxide-Semiconductor Field-Effect Transistor » signifiant transistor à effet de champ Métal-Oxyde-Semiconducteur) classique basée sur le silicium, a été le socle de l'industrie des semiconducteurs.

Pour répondre aux exigences croissantes de densité d'intégration, cette architecture classique a ensuite cédé la place à d'autres types d'architectures mieux adaptées aux performances spécifiées dans les nœuds technologiques inférieurs à 12 nm. L'architecture dite « finFET » permet par exemple de répondre aux performances fixées par les nœuds technologiques 7 nm et 5 nm.

Plus récemment, une architecture de transistors à grille enrobante dits transistors GAA (acronyme de Gate All Around) et à canaux superposés a émergé. Cette architecture répond aux problématiques des prochains nœuds technologiques, notamment à partir de 3 nm et en deçà.

Dans les dispositifs CFET adoptant cette architecture de transistors GAA, deux transistors de type N et P à grilles enrobantes et à structures de canaux empilés distincts sont conventionnellement juxtaposés.

Dans le but d'augmenter la densité d'intégration des dispositifs microélectronique, d'autres architectures GAA pour CFET ont été développées. Le document FR3090998 divulgue une architecture basée sur la superposition de deux transistors GAA de type N et P. Cela permet de réduire l'encombrement du dispositif dans un circuit intégré.

Afin de permettre la réalisation de contacts avec les zones source et drain du transistor inférieur, des éléments conducteurs traversent les régions source et drain du transistor situé au niveau supérieur. Ces éléments conducteurs sont entourés d'une enveloppe isolante.

Le procédé divulgué par ce document reste néanmoins complexe à mettre en œuvre. Le nombre d'étapes de procédé est élevé. Le coût du procédé, qui dépend notamment du nombre d'étapes à mettre en œuvre, est important.

Une fabrication industrielle maîtrisée, satisfaisant aux exigences de qualité requises et limitant les coûts de procédé, est un enjeu important pour le développement des technologies de transistors GAA CFET.

Il existe donc un besoin pour un procédé de fabrication de transistors GAA CFET présentant un coût de fabrication limité.

Un objectif de l'invention est de répondre à ce besoin en proposant un tel procédé de fabrication. Un autre objectif de l'invention est de proposer un dispositif présentant une architecture GAA CFET pouvant être reproduite plus facilement et avec plus de maîtrise. Un autre objectif de l'invention est de pallier au moins en partie les inconvénients des procédés et dispositifs connus.

### RESUME

Pour atteindre cet objectif, selon un mode de réalisation on prévoit un dispositif microélectronique comprenant au moins deux transistors superposés selon une direction principale z, comprenant :
- Un premier transistor d'un premier type, comprenant :
   ∘ au moins deux premiers canaux empilés selon la direction principale z, chaque canal étant à base d'un premier matériau semiconducteur,
   ∘ une première source et un premier drain à base dudit premier matériau semi-conducteur,
   ∘ un premier contact de source et un premier contact de drain connectés respectivement à ladite première source et audit premier drain,
   ∘ une première grille dite enrobante, entourant totalement au moins l'un des premiers canaux,
   ∘ une première couche diélectrique séparant chaque premier canal de la première grille enrobante,
- Un deuxième transistor d'un deuxième type, comprenant :
   ∘ au moins deux deuxièmes canaux empilés selon la direction principale z, chaque canal étant à base d'un deuxième matériau semiconducteur,
   ∘ une deuxième source et un deuxième drain à base dudit deuxième matériau semi-conducteur,
   ∘ un deuxième contact de source et un deuxième contact de drain connectés respectivement à ladite deuxième source et audit deuxième drain,
   ∘ une deuxième grille dite enrobante, entourant totalement au moins l'un des deuxièmes canaux,
   ∘ une deuxième couche diélectrique séparant chaque deuxième canal de la deuxième grille enrobante.

Selon l'invention, le premier contact de source et l'un parmi le deuxième contact de source et le deuxième contact de drain sont distincts et isolés les uns des autres par la première couche diélectrique et par la deuxième couche diélectrique de grille.

Selon l'invention, le premier contact de drain et l'autre parmi le deuxième contact de source et le deuxième contact de drain sont distincts et isolés les uns des autres par ladite première couche diélectrique et par ladite deuxième couche diélectrique.

Dans cette architecture, les première et deuxième couches diélectriques présentent avantageusement au moins deux fonctions : l'isolation des premiers et deuxièmes canaux vis-à-vis des première et deuxième grilles, et l'isolation des premier et deuxième contacts entre eux.

Cette architecture est donc conçue en minimisant le nombre d'éléments distincts. Comme chaque élément distinct requiert typiquement au moins une étape de fabrication, cela permet d'envisager un procédé de fabrication pour cette architecture de dispositif comprenant un nombre d'étapes limité.

Un autre aspect de l'invention concerne un procédé de fabrication d'un tel dispositif microélectronique, comprenant les étapes suivantes :
- Fournir sur un substrat un premier empilement et un deuxième empilement superposés selon la direction z, ledit premier empilement comprenant une pluralité de premières couches en un premier matériau, alternées avec une pluralité de deuxièmes couches en un deuxième matériau, ledit deuxième empilement comprenant une pluralité de troisièmes couches en un troisième matériau, alternées avec une pluralité de quatrièmes couches en un quatrième matériau, lesdits premier et deuxième empilements étant séparés par une couche diélectrique,
- Former, dans le premier empilement et le deuxième empilement superposés, des premières ouvertures définissant des premiers motifs,
- Former une grille sacrificielle à cheval sur les premiers motifs et en partie dans les premières ouvertures,
- Former dans les premiers motifs des deuxièmes ouvertures définissant des deuxièmes motifs, de part et d'autre de la grille sacrificielle,
- Former une première couche sacrificielle dans les deuxièmes ouvertures, sur des flancs des deuxièmes couches du premier empilement,
- Former une deuxième couche sacrificielle sur la première couche sacrificielle et sur des flancs des quatrièmes couches du deuxième empilement, en laissant un espace d'accès à la première couche sacrificielle,
- Retirer la première couche sacrificielle, à partir de l'espace d'accès, en conservant la deuxième couche sacrificielle, de façon à former des premières cavités débouchant sur les flancs des deuxièmes couches du premier empilement,
- Retirer à partir des premières cavités le deuxième matériau des deuxièmes couches sélectivement au premier matériau des premières couches, de sorte à former des deuxièmes espaces,
- Former une première couche diélectrique dans les deuxièmes espaces sur des parties exposées du premier matériau des premières couches, et dans les premières cavités sur des parties exposées de la deuxième couche sacrificielle,
- Déposer une couche à base d'un premier matériau semiconducteur dans les deuxièmes espaces, sur la première couche diélectrique de grille, de sorte à former :
   ∘ les premiers canaux du premier transistor à base du premier matériau semiconducteur, à l'aplomb de la grille sacrificielle,
   ∘ une première source et un premier drain du premier transistor à base du premier matériau semiconducteur, de part et d'autre des premiers canaux du premier transistor,
- Remplir les premières cavités par un premier matériau électriquement conducteur pour former des premiers contacts de source et de drain du premier transistor,
- Retirer la deuxième couche sacrificielle, de façon à former des deuxièmes cavités débouchant sur les flancs des quatrièmes couches du deuxième empilement,
- Retirer à partir des deuxièmes cavités le quatrième matériau des quatrièmes couches sélectivement au troisième matériau des troisièmes couches, de sorte à former des quatrièmes espaces,
- Former une deuxième couche diélectrique dans les quatrièmes espaces sur des parties exposées du troisième matériau des troisièmes couches, et dans les deuxièmes cavités sur la première couche diélectrique de grille,
- Déposer une couche à base d'un deuxième matériau semiconducteur dans les quatrièmes espaces, sur la deuxième couche diélectrique de grille, de sorte à former :
   ∘ des deuxièmes canaux du deuxième transistor à base du deuxième matériau semiconducteur, à l'aplomb de la grille sacrificielle,
   ∘ une deuxième source et un deuxième drain du deuxième transistor à base du deuxième matériau semiconducteur, de part et d'autre des deuxièmes canaux du deuxième transistor,
- Remplir les deuxièmes cavités par un deuxième matériau électriquement conducteur pour former des deuxièmes contacts de source et de drain du deuxième transistor,
- Retirer la grille sacrificielle de sorte à former des troisièmes ouvertures,
- Retirer à partir des troisièmes ouvertures, les premières couches et les troisièmes couches, pour former des premiers espaces et des troisièmes espaces respectivement,
- Remplir les premiers et troisièmes espaces, pour former respectivement les première et deuxième grilles enrobantes des premier et deuxième transistors.

Dans ce procédé, le premier transistor est formé à partir du premier empilement et le deuxième transistor est formé à partir du deuxième empilement. Un principe du procédé selon l'invention consiste à remplacer sélectivement certaines couches des empilements initiaux, ici les premières et troisièmes couches, pour former typiquement deux grilles superposées, entourant des couches à base d'un matériau semiconducteur formant les canaux des transistors, ici les deuxièmes et quatrièmes couches. Les avantages mentionnés ci-dessus pour le dispositif s'appliquent *mutatis mutandis* au procédé selon l'invention. En particulier, le nombre d'étapes est réduit par rapport aux procédés connus.

Selon une possibilité, les deuxièmes et quatrièmes couches sont ultérieurement remplacées par un ou des matériaux semiconducteurs afin de former les canaux des transistors. Dans ce cas, les empilements initiaux ne comprennent pas les matériaux semiconducteurs formant les canaux des transistors. Le dépôt ultérieur des matériaux semiconducteurs vise à mieux préserver les matériaux semiconducteurs. Selon une possibilité préférée, les matériaux semiconducteurs des premiers et deuxièmes canaux sont à base d'un matériau bidimensionnel (2D) choisi parmi les dichalcogénures de métaux de transition MX2 avec M pris parmi le molybdène (Mo) ou le tungstène (W), et X pris parmi le soufre (S) ou le sélénium (Se). Le procédé permet notamment d'introduire des couches de matériau 2D en fin de procédé, après structuration de l'empilement et notamment après la formation des espaceurs. Cela permet avantageusement de limiter le risque de dégradation du matériau 2D au cours du procédé. Le matériau 2D n'est pas exposé à toutes les étapes du procédé de fabrication. Le matériau 2D est ainsi préservé.

Une telle introduction tardive du matériau 2D au cours du procédé de fabrication permet en outre d'utiliser les technologies standard de la microélectronique pour la formation et la structuration de l'empilement. Il n'est pas nécessaire de modifier ou d'adapter les étapes technologiques standard de structuration aux contraintes d'utilisation du matériau 2D. Les coûts du procédé sont ainsi avantageusement limités. Le procédé peut être plus facilement implémenté dans des lignes de production existantes.

Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

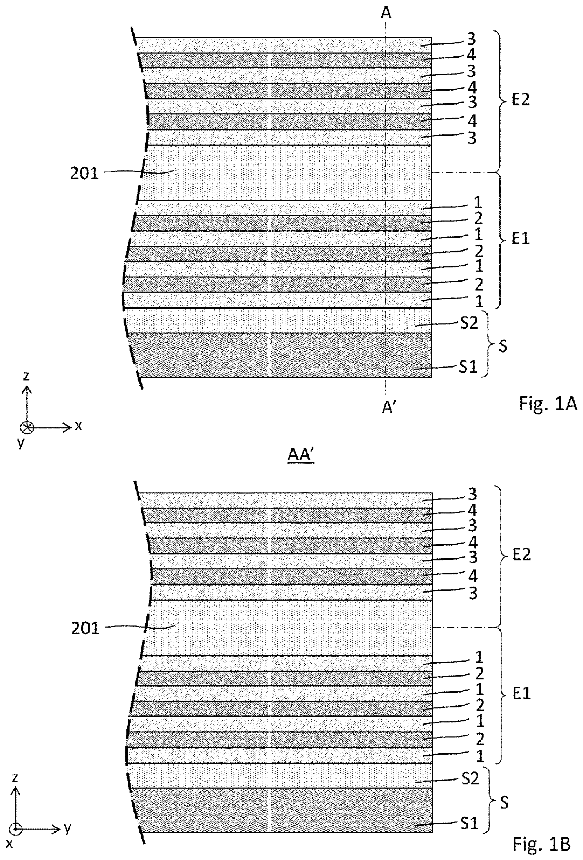

Les figures 1A, 2A, 3A, 4, 5, 6, 7, 8, 9, 10, 11, 12, 13, 14, 15, 16, 17, 18, 19, 20, 21, 22, 23 et 24A illustrent schématiquement selon des coupes transverses xz des étapes de fabrication d'un dispositif à transistors GAA CFET, communes aux premier et deuxième modes de réalisation de la présente invention.
Les figures 1B, 2B, 3B et 24B illustrent schématiquement selon des coupes transverses yz indiquées sur les figures nA correspondantes, les mêmes étapes de fabrication du dispositif que celles représentées dans les figures nA (n=1, 2, 3, 24) respectivement.
Les figures nA (n=25...27) illustrent schématiquement selon des coupes transverses xz les étapes de fabrication d'un dispositif à transistors GAA CFET qui suivent les étapes communes représentées dans les figures 1A, 2A, 3A, 4, ..., 23 et 24A, selon un premier mode de réalisation de la présente invention.
Les figures nB (n=25...27) illustrent schématiquement selon des coupes transverses yz indiquées sur les figures nA correspondantes, les mêmes étapes de fabrication du dispositif que celles représentées dans les figures nA (n=25...27) respectivement, selon un premier mode de réalisation de la présente invention.
Les figures nA (n=28...34) illustrent schématiquement selon des coupes transverses xz les étapes de fabrication d'un dispositif à transistors GAA CFET qui suivent les étapes communes représentées dans les figures 1A, 2A, 3A, 4, ..., 23 et 24A, selon un deuxième mode de réalisation de la présente invention.
Les figures nB (n=28...34) illustrent schématiquement selon des coupes transverses yz indiquées sur les figures nA correspondantes, les mêmes étapes de fabrication du dispositif que celles représentées dans les figures nA (n=28...34) respectivement, selon un deuxième mode de réalisation de la présente invention.

Sur les figures en coupes transverses, des plans de coupe sont indiqués (A-A', B-B', ..., M-M') avec des références croisées aux plans de coupe des figures correspondantes. Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques de l'invention et des caractéristiques optionnelles qui peuvent éventuellement être utilisées en association ou alternativement : Selon l'invention, le premier contact de source et le deuxième contact de source sont distincts et isolés les uns des autres par la première couche diélectrique et par la deuxième couche diélectrique, et le premier contact de drain et le deuxième contact de drain sont distincts et isolés les uns des autres par ladite première couche diélectrique et par ladite deuxième couche diélectrique.

Selon l'invention, le premier contact de source et le deuxième contact de drain sont distincts et isolés les uns des autres par la première couche diélectrique et par la deuxième couche diélectrique, et le premier contact de drain et le deuxième contact de source sont distincts et isolés les uns des autres par ladite première couche diélectrique et par ladite deuxième couche diélectrique.

Selon un exemple, la première couche diélectrique et la deuxième couche diélectrique sont à base du même matériau, formant ainsi une couche diélectrique continue entre les premiers et deuxième contacts de source et entre les premiers et deuxième contacts de drain.

Selon un exemple, le premier matériau semiconducteur présente un premier type de conductivité, par exemple de type N, et le deuxième matériau semiconducteur présente un deuxième type de conductivité différent du premier type de conductivité, par exemple de type P.

Selon un exemple, le premier matériau semiconducteur et/ou le deuxième matériau semiconducteur sont à base d'un matériau bidimensionnel (2D) choisi parmi les dichalcogénures de métaux de transition MX2 avec M pris parmi le molybdène (Mo) ou le tungstène (W), et X pris parmi le soufre (S), le sélénium (Se) ou le tellure (Te).

Selon un autre exemple, le premier matériau semiconducteur et/ou le deuxième matériau semiconducteur sont à base d'un oxyde semiconducteur, par exemple à base d'IGZO (Indium Gallium Zinc Oxide), d'In2O3, d'IWO (tungsten doped indium oxide), d'ITO (Indium Tin Oxide), d'IAZO (Indium Aluminium Zinc Oxide), d'InGaZnO, d'InGaO, d'InZnO ou d'un oxyde semiconducteur amorphe.

Selon un autre exemple, le premier matériau semiconducteur et/ou le deuxième matériau semiconducteur sont à base de graphène, de nitrure de bore hexagonal « h-BN », de phosphorène.

Selon un exemple, les première et deuxième grilles enrobantes forment une même grille commune aux premier et deuxième transistors.

Selon un exemple alternatif, les première et deuxième grilles enrobantes sont distinctes.

Selon un exemple, la première grille entoure totalement chaque premier canal du premier transistor, et la deuxième grille entoure totalement chaque deuxième canal du deuxième transistor.

Selon un exemple, le procédé comprend en outre les étapes optionnelles suivantes :
- Former des premiers espaceurs entre la première grille enrobante et les premiers contacts de source et de drain,
- Former des deuxièmes espaceurs entre la deuxième grille enrobante et les deuxièmes contacts de source et de drain

Selon un exemple, la formation des premiers et deuxièmes espaceurs comprend les étapes suivantes :
- Former de préférence des espaceurs bordant la grille sacrificielle et prenant appui sur les premiers motifs,
- Avant la formation de la première couche sacrificielle, retirer partiellement, à partir des deuxièmes ouvertures, le premier matériau des premières couches sélectivement au deuxième matériau des deuxièmes couches, de sorte à former des premières cavités d'espaceurs, de préférence à l'aplomb des espaceurs,
- Remplir les premières cavités d'espaceurs par un premier matériau diélectrique pour former les premiers espaceurs,
- Avant la formation de la deuxième couche sacrificielle, retirer partiellement, à partir des deuxièmes ouvertures, le troisième matériau des troisièmes couches sélectivement au quatrième matériau des quatrièmes couches, de sorte à former des deuxièmes cavités d'espaceurs, de préférence à l'aplomb des espaceurs,
- Remplir les deuxièmes cavités d'espaceurs par un deuxième matériau diélectrique pour former les deuxièmes espaceurs.

Les premiers et deuxièmes espaceurs sont typiquement appelés espaceurs internes.

Selon un exemple, les premier et deuxième matériaux diélectriques sont identiques.

Selon un exemple, le premier matériau des premières couches est identique au troisième matériau des troisièmes couches.

Selon un exemple, les premiers et deuxièmes espaceurs sont formés simultanément.

Selon un exemple, la grille sacrificielle comprend une première partie et une deuxième parties distinctes.

Selon un exemple, le retrait de la grille sacrificielle comprend :
- un premier retrait de la première partie de grille sacrificielle, configuré pour former une troisième ouverture débouchant uniquement sur des flancs des premières couches, d'un premier côté seulement du premier motif, suivi d'un retrait des premières couches à partir de ladite troisième ouverture pour former les premiers espaces, et un remplissage desdits premiers espaces pour former la première grille enrobante du premier transistor, et
- un deuxième retrait de la deuxième partie de grille sacrificielle, configuré pour former une troisième ouverture débouchant uniquement sur des flancs des troisièmes couches, d'un deuxième côté seulement du premier motif, suivi d'un retrait des troisièmes couches à partir de ladite troisième ouverture pour former les troisièmes espaces, et un remplissage desdits troisièmes espaces pour former la deuxième grille enrobante du deuxième transistor.

Selon un exemple, la deuxième grille enrobante est formée avant la première grille enrobante.

Selon un exemple, le premier retrait comprend une formation d'une portion d'isolation sur des flancs du deuxième empilement au niveau du premier côté du premier motif, avant remplissage des premiers espaces pour former la première grille enrobante.

Selon un exemple, le deuxième retrait comprend une formation d'une deuxième portion d'isolation sur des flancs du premier empilement au niveau du deuxième côté du premier motif, avant remplissage des troisièmes espaces pour former la deuxième grille enrobante.

Selon un exemple, le procédé comprend, avant le retrait de la grille sacrificielle, une séparation de la grille sacrificielle en une première partie et une deuxième partie distinctes, lesdites première et deuxième parties de grille sacrificielle s'étendant respectivement sur les premier et deuxième côtés du premier motif, le premier retrait étant effectué sur la première partie de grille et le deuxième retrait étant effectué sur la deuxième partie de grille.

Selon un exemple, avant formation de la grille sacrificielle, un masque dur est formé sur les premiers motifs, et la séparation de la grille sacrificielle est effectuée par polissage mécano-chimique avec arrêt sur ledit masque dur.

L'invention porte d'une manière générale sur un dispositif microélectronique à transistors GAA et un procédé de fabrication. Un tel dispositif microélectronique peut présenter une architecture de type « GAA stacked nanosheet », c'est-à-dire à nanofeuilles empilées et grille totalement enrobante. Une architecture à nanofils empilés et grille totalement enrobante est également possible.

Les nanofils ou nanofeuilles comprennent typiquement chacun un canal de conduction d'un transistor. Ces canaux sont empilés selon une direction z. Cela signifie qu'ils occupent chacun un niveau d'altitude donnée selon la direction z. Un niveau peut être défini entre deux plans perpendiculaires à la direction z.

De manière avantageuse, le procédé selon l'invention peut être mis en œuvre pour la réalisation de transistors MOS GAA pour les nœuds technologiques 5 nm et sub-5 nm.

Un dispositif microélectronique comprenant des transistors GAA à canaux superposés peut être avantageusement intégré dans des systèmes logiques présentant des architectures 3D. Ces transistors peuvent notamment être associés à d'autres éléments structuraux ou fonctionnels de façon à concevoir des systèmes complexes.

Un aspect particulier de l'invention concerne la mise en œuvre de matériaux 2D pour réaliser les nanofils ou nanofeuilles du dispositif. Ces matériaux 2D présentent des propriétés de semiconducteur, notamment par la présence d'un gap électronique.

Les matériaux 2D correspondent typiquement à des composés présentant une structure lamellaire constituée de feuillets bidimensionnels, empilés selon l'axe cristallographique c. Les liaisons atomiques au sein de chaque feuillet sont fortes, de nature covalente. Les liaisons entre feuillets sont beaucoup plus faibles, de type Van der Waals. Ces feuillets bidimensionnels sont également appelés monocouches.

Dans le cadre de la présente invention, les monocouches sont de préférence des monocouches semiconductrices du type MX2 où M est du molybdène (Mo) ou du tungstène (W) et X du soufre (S) ou du sélénium (Se). Chaque « monocouche » est ici composée d'un plan de cations métalliques M inséré entre deux plans d'anions X. Une monocouche comprend donc ici typiquement trois plans atomiques : les atomes du métal de transition (Mo ou W) forment un plan pris en sandwich entre deux plans de chalcogènes (S, Se ou Te, par exemple). Chaque atome de métal de transition est relié à six atomes de chalcogène. Ces anions sont en coordination trigonale prismatique par rapport aux atomes de métal. Les monocouches de dichalcogénures de métaux de transition MX2 présentent un réseau atomique hexagonal.

Les monocouches de dichalcogénures de métaux de transition MX2 sont de préférence à base de disulfure de molybdène MoS2, MoSe2, MoTe2, WS2, WSe2.

Une possibilité alternative concerne la mise en œuvre d'oxydes semiconducteurs pour réaliser les nanofils ou nanofeuilles du dispositif, par exemple IWO, IGZO, ITO, InGaZnO, InGaO, InZnO, In2O3, IAZO. Une autre possibilité concerne la mise en œuvre de graphène, de nitrure de bore hexagonal « h-BN », de phosphorène (également connu sous le nom de « Black Phosphorous » BP), notamment sous forme de monocouche.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Les différents motifs formés au cours des étapes de fabrication présentent typiquement une structure destinée à évoluer lors des étapes du procédé. Ainsi, les motifs peuvent comprendre les couches sacrificielles des empilements initiaux, les couches à base de matériau 2D ou d'oxyde semiconducteur, les couches diélectriques, continues ou discontinues. Les différents motifs visent à former, en fin de procédé, des « motifs de transistors » comprenant chacun au moins un canal de conduction, une source et un drain de part et d'autre du canal et une grille entourant ledit canal, une barrière diélectrique séparant la grille du canal et les contacts de drain, respectivement de source, entre eux. L'assignation des premières, deuxièmes, troisièmes et quatrièmes couches dans les empilements initiaux peut être inversée ou permutée.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy. Les flancs s'étendent ici typiquement selon un plan yz.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente des exemples de mise en œuvre du procédé selon l'invention dans un contexte d'élaboration d'un dispositif 3D complexe. Le cadre de cette description n'est évidemment pas limitatif de l'invention.

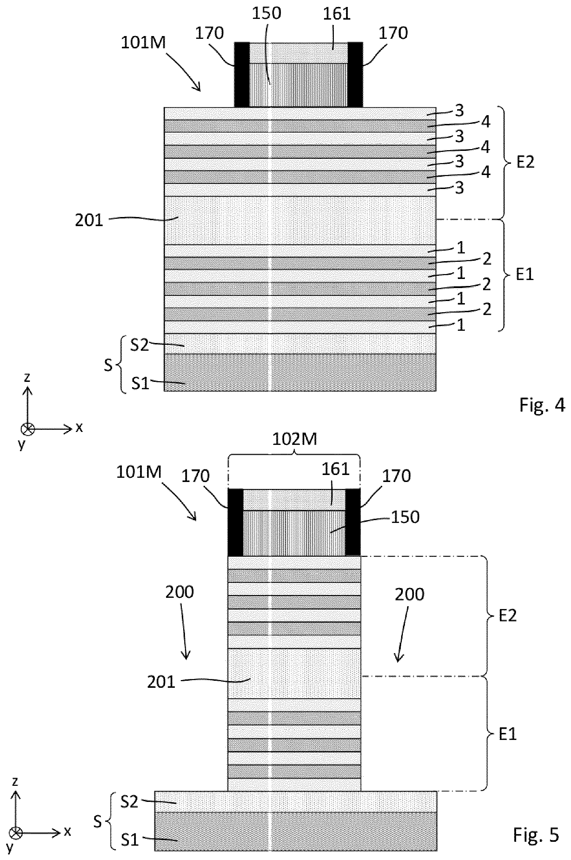

Les figures 1A, 1B, 2A, 2B, 3A, 3B, 4 à 23, 24A, 24B, 25A, 25B, 26A, 26B, 27A, 27B illustrent schématiquement des étapes de fabrication d'un dispositif CFET à transistors GAA superposés ayant des contacts de source et de drain isolés par au moins une couche diélectrique de grille, selon un premier mode de réalisation de la présente invention. Les figures nA (n=1, 2, 3, 24, 25, 26, 27) et les figures 4 à 23 correspondent à des premières coupes transverses selon un plan xz illustrant chacune une étape différente du procédé de fabrication. Les figures nB (n=1, 2, 3, 24, 25, 26, 27) correspondent à des deuxièmes coupes transverses selon un plan yz illustrant chacune la même étape que la figure nA correspondante.

Comme illustré aux figures 1A, 1B, une première étape consiste à réaliser sur un substrat S une superposition selon la direction z d'un premier empilement E1 comprenant une alternance de couches semi-conductrices 1, 2 et d'un deuxième empilement E2 comprenant une alternance de couches semi-conductrices 3, 4, les empilements E1, E2 étant séparés par une couche isolante 201. Le substrat S peut être un substrat de type SOI (Silicon On Insulator), GeOI (Germanium On Insulator) ou SGOI (Silicon-Germanium On Insulator). Ces substrats connus comprennent, selon la terminologie courante pour l'homme du métier, une couche S1 de silicium épaisse dite « Si bulk », une couche S2 d'oxyde de silicium dite « BOX » (Burried Oxide) et une couche mince superficielle, respectivement à base de silicium, de germanium ou de silicium-germanium. Cette couche mince superficielle peut avantageusement correspondre à la première couche 1 du premier empilement E1. Alternativement, le substrat S peut être un substrat massif « Si bulk ».

Le premier empilement E1 comprend selon un exemple une alternance de premières couches 1 en silicium-germanium (SiGe) et de deuxièmes couches 2 en silicium (Si). Avantageusement, le deuxième empilement E2 comprend également une alternance de troisièmes couches 3 en silicium-germanium (SiGe) et de quatrièmes couches 4 en silicium (Si). D'une façon générale, le couple de matériaux formant les troisièmes couches 3 et les quatrièmes couches 4 du deuxième empilement E2 peut être différent du couple des matériaux formant les premières couches 1 et les deuxièmes couches 2 du premier empilement E1. Dans ce qui suit, le même couple de matériaux formant les couches 1, 2 et les couches 3, 4 est adopté.

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe.

Le premier empilement E1 est typiquement formé sur un premier substrat et le deuxième empilement E2 est typiquement formé séparément sur un deuxième substrat. L'alternance des couches 1, 2 et 3, 4 dans les empilements respectifs E1, E2 est avantageusement formé par épitaxie des couches de SiGe 1, 3 et de Si 2, 4. Cette étape de formation de chaque empilement E1, E2 est peu coûteuse et bien connue de l'homme du métier. Les épaisseurs des couches Si et SiGe peuvent être typiquement de l'ordre de 10 nm, et plus généralement comprises entre 5 nm et 20 nm par exemple. De façon connue afin d'éviter la formation de défauts structuraux, les épaisseurs maximales permises pour les couches 1, 3 en SiGe dépendent notamment de la concentration en Ge choisie.

Un dépôt d'oxyde, par exemple à base de SiO₂, est de préférence effectué sur chaque empilement E1, E2. L'assemblage et la superposition des deux empilements E1, E2, peut alors être réalisée de façon connue par report et collage oxyde/oxyde. Après collage, le premier empilement E1 est ainsi séparé du deuxième empilement E2 par une couche isolante 201 continue, dont l'épaisseur peut être typiquement comprise entre 10 nm et 100 nm.

Dans l'exemple illustré aux figures 1A, 1B, quatre couches 1, 3 de SiGe sont respectivement alternées avec trois couches 2, 4 de Si épitaxiées. Un super réseau Si/SiGe est ainsi obtenu. Le nombre de couches de Si et de SiGe peut naturellement être augmenté. Cela permet *in fine* d'augmenter le nombre de canaux empilés par transistor dans le dispositif final.

D'une façon générale le ou les matériaux formant les couches 1, 3 et le ou les matériaux formant les couches 2, 4 sont choisis de façon à ce que les uns puissent être gravés sélectivement par rapport aux autres, en particulier celui des couches 1 vis-à-vis de celui des couches 2 ou inversement, et celui des couches 3 vis-à-vis de celui des couches 4 ou inversement. Ainsi, d'autres couples de matériaux sont possibles. En respectant cette condition de sélectivité à la gravure, les matériaux formant les couches 1, 2, 3, 4 peuvent être choisis parmi les matériaux diélectriques (oxydes et nitrures par exemple), les matériaux semiconducteurs, les matériaux métalliques.

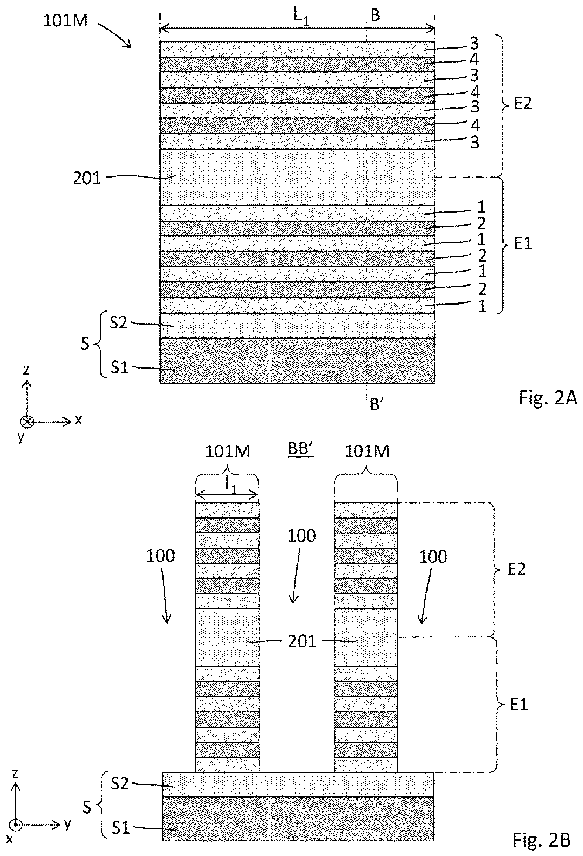

Comme illustré aux figures 2A, 2B, une étape classique de lithographie/gravure est réalisée afin de définir des premiers motifs 101M, et des premières ouvertures 100. La gravure est anisotrope et dirigée selon z. Elle est configurée pour graver l'ensemble des empilements E1, E2, ici les deux super réseaux Si/SiGe séparés par la couche isolante 201, sur toute sa hauteur, en s'arrêtant sur le substrat S, ici le BOX S2. Elle peut être effectuée par plasma en utilisant une chimie de gravure HBr/O2. Les premiers motifs 101M peuvent présenter une longueur L₁ selon x comprise entre 10 nm et 500 nm. Ils présentent de préférence une largeur I₁ selon y comprise entre 10 nm et 120 nm, par exemple de l'ordre de 40 nm. Cette première structuration des empilements E1, E2 sous forme d'ailettes ou « fins » selon la terminologie anglo-saxonne courante, permet de définir une pluralité de nanofils ou de nanosheets superposés.

Par souci de clarté les figures suivantes iB (i=3, 24, ..., 34) n'illustrent qu'un seul motif de « fin » 101M.

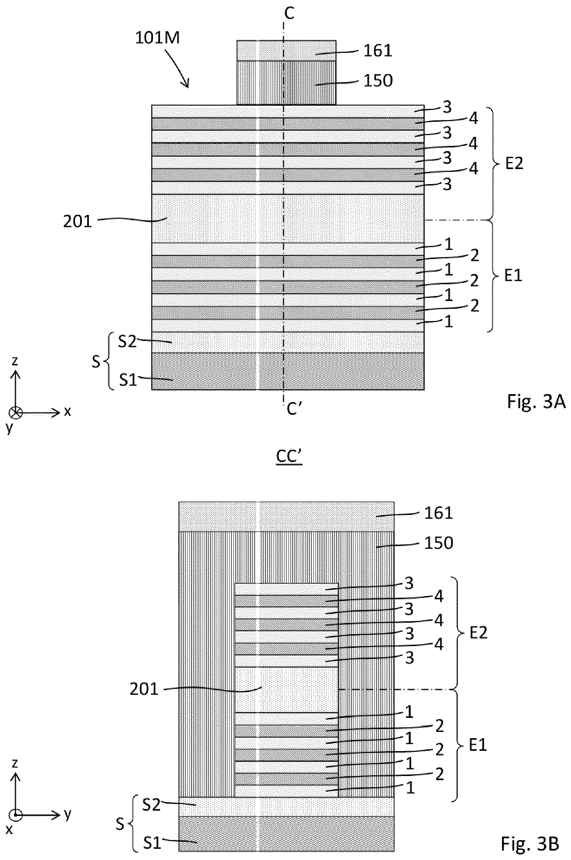

Comme illustré aux figures 3A, 3B, des grilles sacrificielles 150 sont ensuite formées sur les motifs de « fin » 101M. La formation de ces grilles sacrificielles 150 se fait typiquement par dépôt puis lithographie/gravure. La formation des grilles sacrificielles 150 est configurée de sorte que les grilles sacrificielles 150 soient à cheval sur les motifs de « fin » 101M, comme illustré en figure 3B. Les grilles sacrificielles 150 comprennent typiquement une partie supérieure située sur le motif de « fin » 101M, et des parties latérales situées sur les flancs latéraux du motif de « fin » 101M. Les grilles sacrificielles 150 prennent typiquement appui sur le substrat S. A ce stade, les grilles sacrificielles 150 sont typiquement surmontées par un masque de gravure 161, dit masque dur, mis en œuvre dans la structuration des grilles sacrificielles 150. Les grilles sacrificielles 150 comprennent par exemple de façon connue une couche d'oxyde mince SiO2 (épaisseur entre 3 nm et 7 nm par exemple) et une couche épaisse de silicium polycristallin ou de silicium amorphe. La couche d'oxyde mince SiO2 (non illustrée sur les figures) peut former une couche d'arrêt lors de la gravure du silicium polycristallin des grilles sacrificielles 150. Cette couche d'oxyde mince SiO2 est ainsi intercalée entre les grilles sacrificielles 150 et les motifs de « fin » 101M. Le masque dur 161 peut être à base d'oxyde de silicium SiO2, de nitrure de silicium SiN, ou d'une bicouche SiO2/SiN.

Comme illustré à la figure 4, des espaceurs 170 sont ensuite formés sur les flancs orientés selon yz des grilles sacrificielles 150. En général, en projection selon z, ces espaceurs forment une bague continue autour de chaque grille sacrificielle 150, avec un contour fermé. En coupe transverse cependant, selon le plan xz illustré à la figure 4, l'espaceur 170 présente deux parties en vis-à-vis sur chacun des flancs de la grille sacrificielle 150. Ces deux parties sont généralement désignées comme étant les espaceurs 170, même si celles-ci peuvent être considérées comme appartenant à un seul et même espaceur. Les espaceurs 170 s'étendent typiquement jusqu'à une face supérieure du masque dur 161. Les espaceurs 170 sont typiquement à base de nitrure de silicium SiN ou d'un matériau diélectrique à faible constante diélectrique, par exemple à base de SiCO.

Comme illustré à la figure 5, après formation des espaceurs 170 par dépôt/gravure, la gravure anisotrope selon z est prolongée afin de définir des deuxièmes motifs 102M, et des deuxièmes ouvertures 200. La gravure est configurée pour graver l'ensemble des empilements E1, E2 sur toute sa hauteur, en s'arrêtant sur le substrat S. Elle peut être effectuée par plasma en utilisant une chimie de gravure HBr/O2.

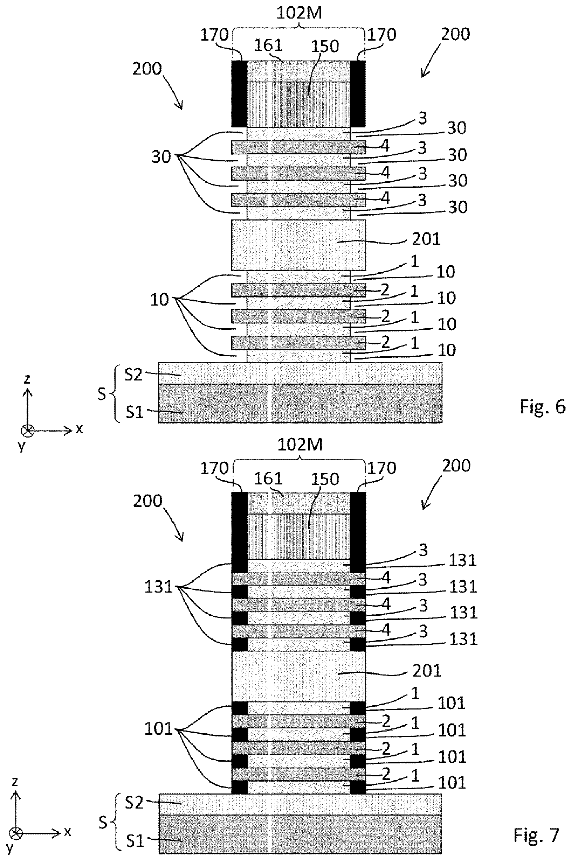

Comme illustré à la figure 6, après formation des deuxièmes ouvertures 200, les premières couches 1 et les troisièmes couches 3 sont partiellement gravées sélectivement aux deuxièmes couches 2 et aux quatrièmes couches 4 respectivement, à la couche isolante 201, au substrat S et aux espaceurs 170. Les premières couches 1 et les troisièmes couches 3 sont avantageusement gravées par une même gravure. La gravure du matériau des couches 1, 3 présente typiquement une sélectivité S_{1:2} (S_{3:4}) par rapport au matériau des couches 2, 4, d'au moins 5:1, de préférence au moins 10:1. Cette gravure partielle vise à former des premiers et troisièmes espaces 10, 30 à l'aplomb des espaceurs 170 respectivement dans les premières et troisièmes couches 1, 3. Cette gravure partielle est typiquement arrêtée au temps. Elle présente un caractère isotrope et peut être effectuée par voie humide ou par voie sèche, à partir des deuxièmes ouvertures 200. A l'issue de cette gravure partielle, des parties centrales des couches 1, 3 sont conservées sous les grilles sacrificielles 150.

Comme illustré à la figure 7, les premiers et troisièmes espaces 10, 30 sont ensuite remplis par un matériau diélectrique, par exemple par du nitrure de silicium ou par un diélectrique à faible permittivité, pour former des premiers et troisièmes espaceurs internes 101, 131. Ces espaceurs « internes » 101, 131 sont intégrés dans les empilements E1, E2, de préférence à l'aplomb des espaceurs 170. Ils sont au contact des parties centrales des couches 1, 3. La formation des espaceurs internes 101, 131 se fait typiquement à partir des deuxièmes ouvertures 200.

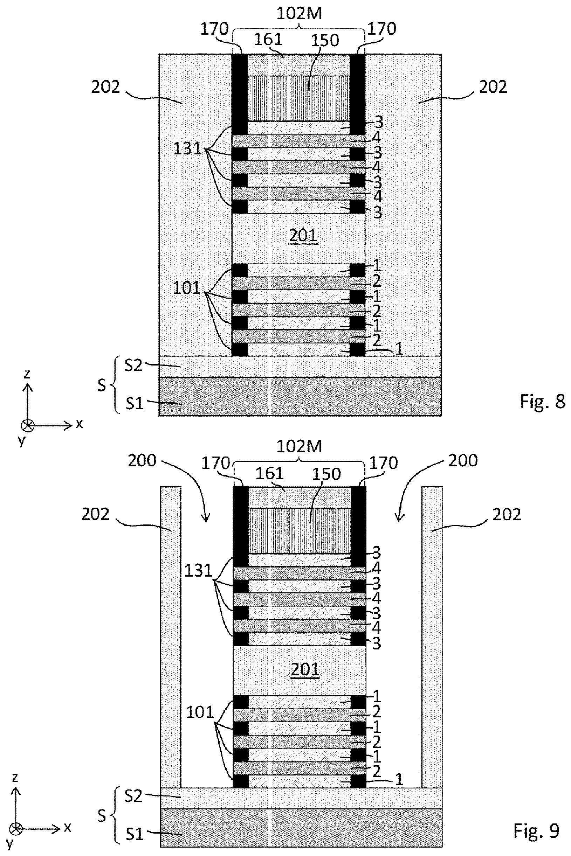

Comme illustré à la figure 8, une couche diélectrique 202, par exemple à base de SiO₂, est déposée sur et entre les deuxièmes motifs 102M de façon à combler les ouvertures 200. Cette couche diélectrique 202 est ensuite planarisée, typiquement par polissage mécano-chimique CMP avec arrêt sur le masque dur 161.

Comme illustré à la figure 9, la couche diélectrique 202 est ouverte par gravure de façon à reformer en partie les deuxièmes ouvertures 200. Les deuxièmes ouvertures 200 définissent ici l'emplacement des contacts des deux transistors empilés.

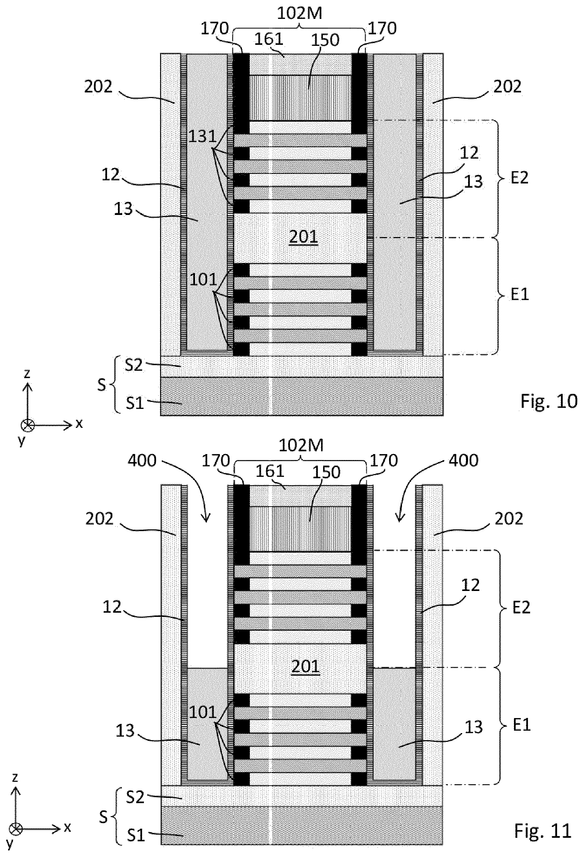

Comme illustré à la figure 10, une couche d'oxyde 12 conforme est de préférence d'abord déposée dans les ouvertures 200. La couche d'oxyde 12 couvre les flancs et le fond des deuxièmes ouvertures 200. Une première couche sacrificielle 13 est ensuite déposée dans les deuxièmes ouvertures 200 sur la couche d'oxyde 12, de sorte à remplir les deuxièmes ouvertures 200. Cette première couche sacrificielle 13 est typiquement à base de silicium polycristallin ou de silicium amorphe. La couche d'oxyde 12 et la couche sacrificielle 13 sont ensuite typiquement planarisées par polissage mécano-chimique CMP avec arrêt sur le masque dur 161.

Comme illustré à la figure 11, la première couche sacrificielle 13 est ensuite partiellement retirée par gravure humide de façon à former un espace d'accès 400 situé en vis-à-vis des couches 3, 4 du deuxième empilement. La gravure est configurée de façon à ce que la partie restante de la première couche sacrificielle 13 s'étende selon z jusqu'à la couche isolante 201. Cette gravure humide peut être à base d'une solution de sels d'ammoniaque TMAH (Hydroxyde de tétraméthylammonium) ou TEAH (Hydroxyde de tétraéthylammonium).

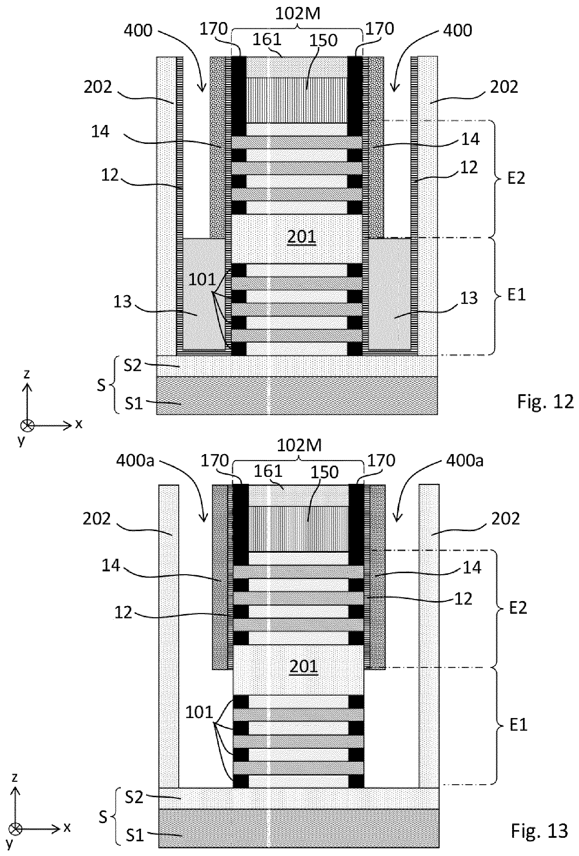

Comme illustré à la figure 12, une deuxième couche sacrificielle 14, par exemple à base de SiO₂, est formée dans l'espace d'accès 400, contre le motif 102M et sur la partie restante de la première couche sacrificielle 13. La formation de cette deuxième couche sacrificielle 14 se fait typiquement par dépôt puis gravure. La deuxième couche sacrificielle 14 s'étend typiquement selon z depuis la couche isolante 201 jusqu'à la face supérieure du masque dur 161.

Comme illustré à la figure 13, la partie restante de la première couche sacrificielle 13 est ensuite retirée à partir l'espace d'accès 400, par gravure sélective vis-à-vis de la deuxième couche sacrificielle 14, typiquement par gravure humide. La partie exposée de la couche d'oxyde 12 est également retirée à partir de l'espace d'accès 400, pour former des premières cavités 400a débouchant sur les flancs des deuxièmes couches 2 du premier empilement E1. La partie non exposée de la couche d'oxyde 12, située entre la deuxième couche sacrificielle 14 et les flancs du deuxième empilement, est conservée.

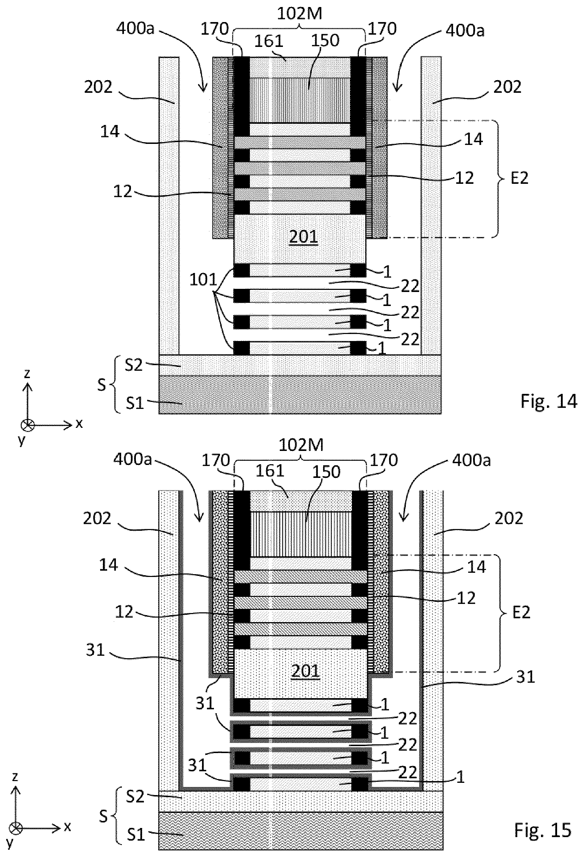

Comme illustré à la figure 14, les deuxièmes couches 2 du premier empilement E1 sont ensuite gravées sélectivement aux parties centrales des premières couches 1 et aux espaceurs internes 101 du premier empilement E1. La gravure du matériau des deuxièmes couches 2 présente typiquement une sélectivité S_{2:1} par rapport au matériau des premières couches 1, d'au moins 5:1, de préférence au moins 10:1. Cette gravure totale peut être arrêtée au temps, possiblement après un temps de surgravure visant à garantir le retrait total des deuxièmes couches 2. Cette gravure totale présente un caractère isotrope et peut être effectuée par voie humide ou par voie sèche, à partir des premières cavités 400a. A l'issue de cette gravure, les deuxièmes couches 2 sont retirées totalement pour former des deuxièmes espaces 22. Les parties centrales des premières couches 1 sont maintenues par les grilles sacrificielles 150.

Comme illustré à la figure 15, une première couche diélectrique 31 est ensuite déposée dans les deuxièmes espaces 22 à partir des premières cavités 400a. Cette première couche diélectrique 31 est typiquement à base d'un matériau à forte permittivité, par exemple à base de HfO₂. La première couche diélectrique 31 est destinée à former au moins en partie la couche diélectrique entre les canaux du premier transistor et de la première grille enrobante. Elle peut être formée par dépôt chimique en phase vapeur CVD (acronyme de « Chemical Vapor Deposition »), par dépôt chimique en phase vapeur à précurseurs organométalliques MOCVD (acronyme de « Metal Organic Chemical Vapor Deposition ») ou par dépôt en couche atomique ALD (acronyme de « Atomic Layer Deposition »). Elle recouvre ainsi au moins les parties centrales des premières couches 1 et, dans les premières cavités 400a, les faces exposées de la deuxième couche sacrificielle 14 et de la couche d'oxyde 12. La première couche diélectrique 31 présente typiquement une épaisseur comprise entre 1 nm et 5 nm.

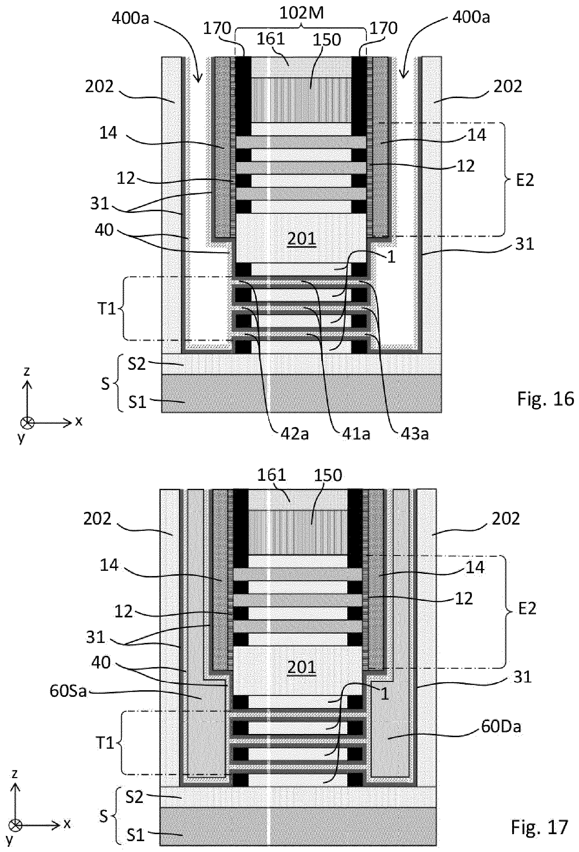

Comme illustré à la figure 16, une couche 40 à base d'un premier matériau semiconducteur est ensuite déposée sur la première couche diélectrique 31 dans les deuxièmes espaces 22. Le dépôt du premier matériau semiconducteur est ici configuré pour que la couche 40 remplisse totalement les deuxièmes espaces 22. Les portions de la couche 40 situées dans les deuxièmes espaces 22 présentent ainsi une épaisseur parfaitement contrôlée, proche de l'épaisseur des deuxièmes couches initiales. Cette couche 40 est destinée à former les canaux 41a du premier transistor T1, à l'aplomb de la grille sacrificielle 150 et des parties centrales des premières couches 1. Cette couche 40 est également destinée à former les sources 42a et les drains 43a du premier transistor T1 à l'aplomb des premiers espaceurs internes 101.

La couche 40 est également typiquement déposée en dehors des deuxièmes espaces 22, sur les flancs des espaceurs internes 101. Cela permet d'améliorer la reprise de contact avec les sources 42a et les drains 43a du premier transistor T1. La couche 40 présente ainsi des portions horizontales dans les deuxièmes espaces 22, notamment entre les parties restantes des premières couches 1, et des portions verticales sur les flancs des premiers espaceurs internes 101. Selon une possibilité, l'épaisseur des portions verticales de la couche 40 est plus importante que l'épaisseur des portions horizontales de la couche 40. Cela permet de réduire la résistance de contact pour les sources 42a et les drains 43a du premier transistor T1. Les sources 42a et les drains 43a du premier transistor T1 peuvent comprendre les portions horizontales à l'aplomb des espaceurs internes 101, et au moins en partie les portions verticales sur les flancs des espaceurs internes 101.

Le premier matériau semiconducteur de la couche 40 est avantageusement un matériau bidimensionnel pris parmi les dichalcogénures de métaux de transition, MoS₂ par exemple pour un premier transistor de type N, et WSe₂ ou WS₂ pour un premier transistor de type P. Un tel matériau 2D peut être avantageusement déposé sous forme de couche mince comprenant 1 à 10 couches atomiques, de préférence 1 à 5 couches atomiques. Le dépôt de ce matériau 2D peut se faire par CVD, MOCVD ou ALD. Selon une autre possibilité, le matériau semiconducteur de la couche 40 est un oxyde semiconducteur tel que l'ITO (acronyme de « Oxyde d'étain-indium»), l'IGZO (acronyme de Oxyde de zinc-indium-gallium »), l'IWO (signifiant « Oxyde d'indium dopé au tungstène »), l'oxyde d'indium In₂O₃.

Selon une deuxième variante non illustrée, la couche 40 à base du premier matériau semiconducteur est déposée sur la première couche diélectrique 31 dans les deuxièmes espaces 22 sans remplir totalement les deuxièmes espaces 22. Dans ce cas, les portions de la couche 40 situées dans les deuxièmes espaces 22 peuvent être significativement plus minces que les deuxièmes couches initiales. Ces portions horizontales peuvent présenter une épaisseur correspondant à quelques couches atomiques seulement, par exemple entre 1 et 5 couches atomiques du premier matériau semiconducteur. La réduction d'épaisseur de la couche 40 permet d'améliorer le contrôle électrostatique du premier transistor et donc de réduire les dimensions des canaux 41a du premier transistor T1. Les performances du premier transistor T1 peuvent être améliorées. Selon cette deuxième variante, un bouchon diélectrique est ensuite formé entre les portions horizontales de la couche 40, afin de remplir les deuxièmes espaces 22. Cela permet d'isoler électriquement les canaux 41a du premier transistor T1 entre eux. Cela permet également d'améliorer la résistance mécanique du dispositif et/ou d'éviter des déformations des canaux 41a du premier transistor T1, par exemple par échauffement lors de son fonctionnement. Ce bouchon diélectrique peut être formé par un dépôt CVD ou ALD suivi d'une gravure isotrope selon z, de façon classique.

Comme illustré à la figure 17, les premières cavités 400a peuvent ensuite être remplies par un ou plusieurs matériaux métalliques pour former les premiers contacts de source et de drain 60Sa, 60Da des premiers transistors T1. Ces matériaux métalliques sont par exemple à base de Ti, TiN, W, ou d'autres métaux permettant d'assurer une faible résistance de contact tels que Bi, Ni, Au, Sb, *etc.* Un polissage mécano-chimique CMP est typiquement effectué afin de retirer l'excès de métal déposé sur les motifs 102M.

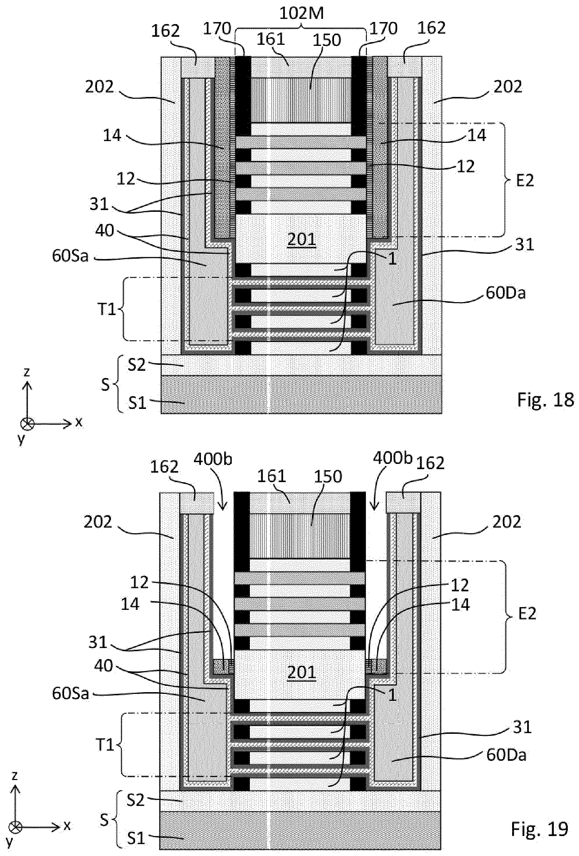

Comme illustré à la figure 18, une étape avantageuse consiste à former des bouchons de protection 162 visant à protéger les premiers contacts de source et de drain 60Sa, 60Da lors des étapes ultérieures de fabrication du deuxième transistor. Les bouchons de protection 162 peuvent être à base d'oxyde de silicium SiO₂, de nitrure de silicium SiN, ou d'une bicouche SiO2/SiN.

Comme illustré à la figure 19, la couche d'oxyde 12 et la deuxième couche sacrificielle 14 sont ensuite retirée au moins partiellement de façon à définir des deuxièmes cavités 400b débouchant sur les flancs des quatrièmes couches 4 du deuxième empilement E2. Selon une possibilité, une partie de la couche d'oxyde 12 et une partie de la deuxième couche sacrificielle 14 sont conservées au niveau de la couche diélectrique 201, comme illustré en figure 19. Selon une autre possibilité non illustrée, la couche d'oxyde 12 et la deuxième couche sacrificielle 14 sont totalement retirées.

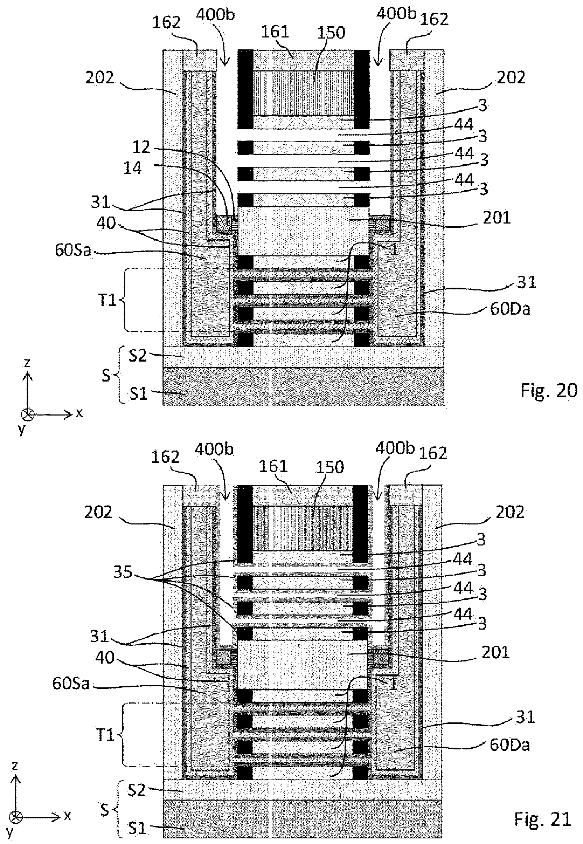

Comme illustré à la figure 20, les quatrièmes couches 4 du deuxième empilement E2 sont ensuite gravées sélectivement aux parties centrales des troisièmes couches 3 et aux espaceurs internes 131. La gravure du matériau des quatrièmes couches 4 présente typiquement une sélectivité S_{4:3} par rapport au matériau des troisièmes couches 3, d'au moins 5:1, de préférence au moins 10:1. Cette gravure totale peut être arrêtée au temps, possiblement après un temps de surgravure visant à garantir le retrait total des quatrièmes couches 4. Cette gravure totale présente un caractère isotrope et peut être effectuée par voie humide ou par voie sèche, à partir des deuxièmes cavités 400b. A l'issue de cette gravure, les quatrièmes couches 4 sont retirées totalement pour former des quatrièmes espaces 44. Les parties centrales des troisièmes couches 3 sont maintenues par les grilles sacrificielles 150.

Comme illustré à la figure 21, une deuxième couche diélectrique 35 est ensuite déposée dans les quatrièmes espaces 44 à partir des deuxièmes cavités 400b. Cette deuxième couche diélectrique 35 est typiquement à base d'un matériau à forte permittivité, par exemple à base de HfO₂. La deuxième couche diélectrique 35 est destinée à former la couche diélectrique entre les canaux du deuxième transistor T2 et la deuxième grille enrobante. Elle peut être formée par CVD, MOCVD ou par ALD. Elle recouvre ainsi au moins les parties centrales des troisièmes couches 3 et la partie exposée de la première couche diélectrique 31, et de préférence les espaceurs 170 et les espaceurs internes 131. La deuxième couche diélectrique 35 présente typiquement une épaisseur comprise entre 1 nm et 5 nm. Elle peut être à base du même matériau formant la première couche diélectrique 31. Les première et deuxième couches diélectriques 31, 35 forment alors une couche continue d'isolation sur une partie supérieure des premiers contacts de source et de drain 60Sa, 60Da, en vis-à-vis des deuxièmes cavités 400b. Selon une autre possibilité, les première et deuxième couches diélectriques 31, 35 sont à base de deux matériaux diélectriques différents. Dans tous les cas, les première et deuxième couches diélectriques 31, 35 sont au contact l'une de l'autre au moins au niveau de la partie supérieure des premiers contacts de source et de drain 60Sa, 60Da, en vis-à-vis des deuxièmes cavités 400b.

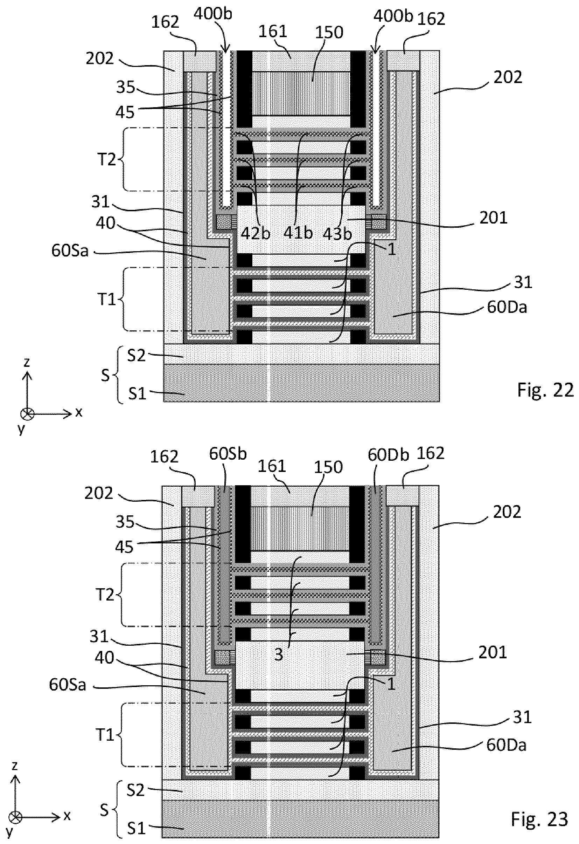

Comme illustré à la figure 22, une couche 45 à base d'un deuxième matériau semiconducteur est ensuite déposée sur la deuxième couche diélectrique 35 dans les quatrièmes espaces 44 et dans les deuxièmes cavités 400b. Comme précédemment, le dépôt du deuxième matériau semiconducteur est ici configuré pour que la couche 45 remplisse totalement les quatrièmes espaces 44. Les portions de la couche 45 situées dans les quatrièmes espaces 44 présentent ainsi une épaisseur parfaitement contrôlée, proche de l'épaisseur des quatrièmes couches initiales. Cette couche 45 est destinée à former les canaux 41b du deuxième transistor T2 à l'aplomb de la grille sacrificielle 150 et des parties centrales des troisièmes couches 3. Cette couche 45 est également destinée à former les sources 42b et les drains 43b du deuxième transistor T2 à l'aplomb des espaceurs 170 et des espaceurs internes 131.

La couche 45 est également typiquement déposée en dehors des quatrièmes espaces 44, sur les flancs des espaceurs 170 et des espaceurs internes 131. Cela permet d'améliorer la reprise de contact avec les sources 42b et les drains 43b du deuxième transistor T2. La couche 45 présente ainsi des portions horizontales dans les quatrièmes espaces 44, notamment entre les parties restantes des troisièmes couches 3, et des portions verticales sur les flancs des espaceurs 170 et des espaceurs internes 131. Selon une possibilité, l'épaisseur des portions verticales de la couche 45 est plus importante que l'épaisseur des portions horizontales de la couche 45. Cela permet de réduire la résistance de contact pour les sources 42b et les drains 43b du deuxième transistor T2. Les sources 42b et les drains 43b du deuxième transistor T2 peuvent comprendre les portions horizontales à l'aplomb des espaceurs 170 et des espaceurs internes 131, et au moins en partie les portions verticales sur les flancs des espaceurs 170 et des espaceurs internes 131.

Le deuxième matériau semiconducteur de la couche 45 est choisi de sorte à former un deuxième transistor T2 présentant une conductivité de type opposé à celle du premier transistor T1. Ce deuxième matériau semiconducteur de la couche 45 est également de préférence un matériau bidimensionnel pris parmi les dichalcogénures de métaux de transition, MoS₂ par exemple pour un deuxième transistor de type N, et WSe₂ ou WS₂ pour un deuxième transistor de type P. Selon une autre possibilité, le deuxième matériau semiconducteur de la couche 45 est un oxyde semiconducteur tel que l'ITO (acronyme de « Oxyde d'étain-indium »), l'IGZO (acronyme de « Oxyde de zinc-indium-gallium »), l'IWO (signifiant « Oxyde d'indium dopé au tungstène»), l'oxyde d'indium In₂O₃.

La couche 45 à base du deuxième matériau semiconducteur peut également être réalisée suivant la deuxième variante décrite précédemment.

Comme illustré à la figure 23, les deuxièmes cavités 400b peuvent ensuite être remplies par un ou plusieurs matériaux métalliques pour former les deuxièmes contacts de source et de drain 60Sb, 60Db du deuxième transistor T2. Ces matériaux métalliques sont par exemple à base de Ti, TiN, W, ou d'autres métaux permettant d'assurer une faible résistance de contact tels que Bi, Ni, Au, Sb, *etc.* Un polissage mécano-chimique CMP est typiquement effectué afin de retirer l'excès de métal déposé sur les motifs 102M.

A ce stade du procédé, le dispositif CFET comprend des transistors T1, T2 superposés ou empilés selon z. Les canaux 41a, 41b de chaque transistor T1, T2 ont été formés et sont également empilés selon z. Les contacts de source 60Sa, 60Sb et de drain 60Da, 60Db de chaque transistor T1, T2 ont également été réalisés. Le premier contact de source 60Sa est avantageusement isolé vis-à-vis du deuxième contact de source 60Sb par la combinaison des première et deuxième couches diélectriques 31, 35. Le premier contact de drain 60Da est avantageusement isolé vis-à-vis du deuxième contact de drain 60Db par la combinaison des première et deuxième couches diélectriques 31, 35.

Afin d'obtenir des transistors GAA superposés, les étapes décrites ci-après concernent la réalisation des grilles fonctionnelles enrobantes des transistors, en remplacement de la grille sacrificielle et des couches 1 et 3, selon deux modes de réalisation.

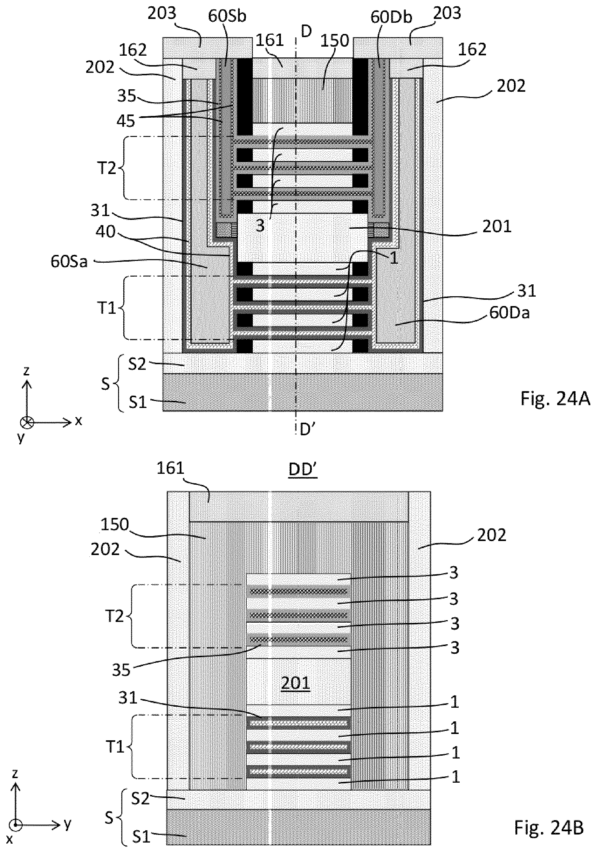

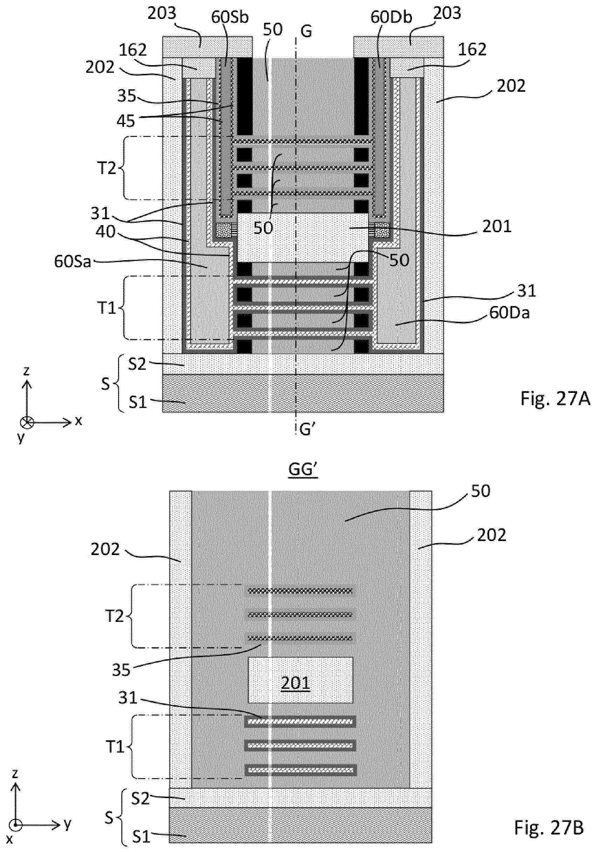

Les figures 24A, 24B à 27A, 27B illustrent schématiquement selon le premier mode de réalisation de la présente invention, la réalisation d'une grille commune aux transistors T1, T2 du dispositif CFET.

Selon ce premier mode de réalisation, comme illustré aux figures 24A, 24B, un masque 203 est formé de sorte à protéger les premiers contacts de source et de drain 60Sa, 60Da et les deuxièmes contacts de source et de drain 60Sb, 60Db. Ce masque 203 est ouvert de façon à exposer le masque dur 161 surmontant la grille sacrificielle. Ce masque 203 peut être classiquement à base d'un matériau diélectrique, par exemple à base de SiN ou de SiO2.

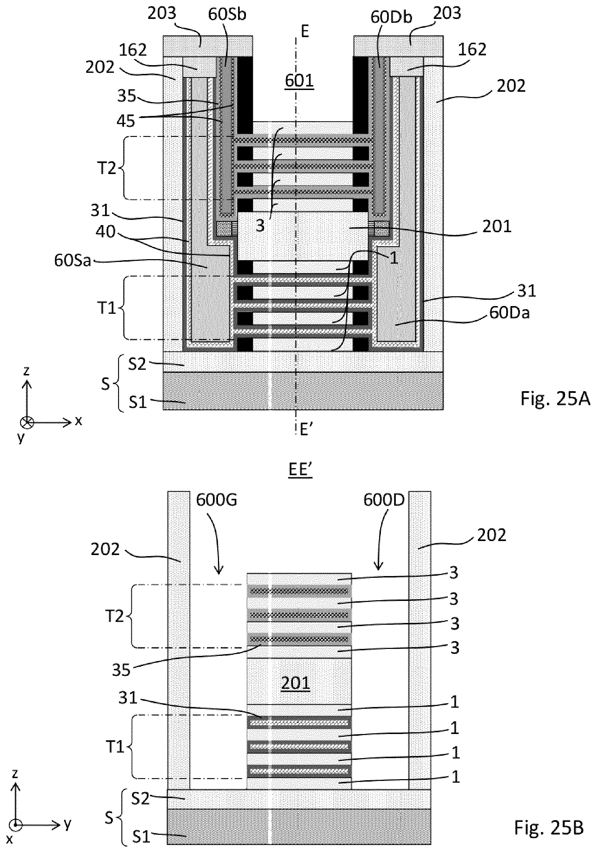

Selon le premier mode de réalisation, comme illustré aux figures 25A, 25B, le masque dur 161 est d'abord retiré, puis la grille sacrificielle 150 est également retirée. Ce dernier retrait peut être effectué par gravure humide avec arrêt sur la fine couche d'arrêt à base de SiO2 ou d'un autre diélectrique. Cette gravure humide présente typiquement une sélectivité élevée vis-à-vis de la couche d'arrêt et/ou des espaceurs 170. Cette gravure humide peut être à base d'une solution de sels d'ammoniaque TMAH (Hydroxyde de tétraméthylammonium) ou TEAH (Hydroxyde de tétraéthylammonium). Ce retrait de la grille sacrificielle 150 permet de former un espace principal 601 et des troisièmes ouvertures 600G, 600D débouchant sur les parties centrales des premières couches 1 et des troisièmes couches 3 (figure 25B).

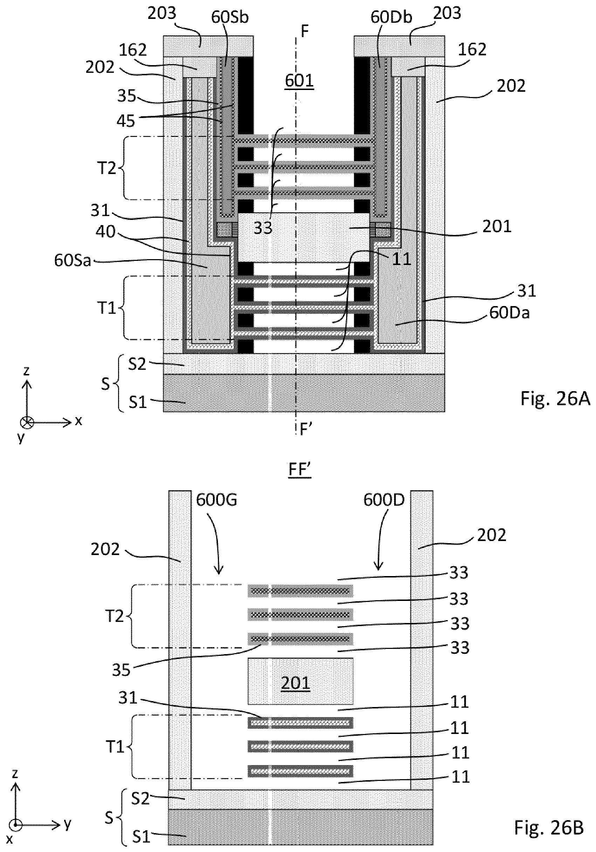

Comme illustré aux figures 26A, 26B, les parties centrales des premières couches 1 et des troisièmes couches 3 sont ensuite totalement gravées sélectivement aux espaceurs internes 101, 131, à la couche isolante 201, à la première couche diélectrique 31 et à la deuxième couche diélectrique 35 à partir des troisièmes ouvertures 600G, 600D. Une ou plusieurs gravures peuvent être mises en œuvre, selon que les matériaux des premières couches 1 et des troisièmes couches 3 sont identiques ou différents. Pour simplifier, une seule gravure est évoquée ici. Cette gravure vise à former des premiers espaces 11 à la place des parties centrales des premières couches 1, et des troisièmes espaces 33 à la place des parties centrales des troisièmes couches 3. Cette gravure totale peut être arrêtée au temps, possiblement après un temps de sur-gravure visant à garantir le retrait total du premier matériau des premières couches 1 et le retrait total du troisième matériau des troisièmes couches 3. Cette gravure totale présente un caractère isotrope et peut être effectuée par voie humide ou par voie sèche, à partir des troisièmes ouvertures 600G, 600D.

Comme illustré aux figures 27A, 27B, les troisièmes ouvertures 600G, 600D, l'espace principal 601, les premiers espaces 11 et les troisièmes espaces 33 sont ensuite remplies par une ou plusieurs couches métalliques, par exemple à base de TiN, W, afin de former une grille 50 commune aux premier et deuxième transistors T1, T2. Cette grille 50 est dite enrobante et entoure totalement les canaux 41a, 41b des premier et deuxième transistors T1, T2. Selon une possibilité, avant dépôt des couches métalliques de la grille 50, une couche diélectrique à base d'un matériau à forte permittivité, par exemple à base de HfO2, est préalablement déposée via les troisièmes ouvertures 600G, 600D, dans l'espace principal 601, les premiers espaces 11 et les troisièmes espaces 33. Cela permet d'augmenter l'épaisseur des couches diélectriques 31, 35 entre les canaux des transistors T1, T2 et la grille 50 enrobante. Un polissage mécano-chimique CMP est typiquement effectué afin de retirer l'excès de métal déposé sur les motifs 102M. Ce procédé dans lequel la grille fonctionnelle 50 est réalisée en fin de procédé, après formation des autres éléments des transistors T1, T2, en particulier après formation des canaux 41a, 41b, est appelé « gate last ».

Selon une autre possibilité non illustrée, la grille 50 commune aux transistors T1, T2 peut être réalisée avant la formation des canaux 41a, 41b des transistors T1, T2, notamment avant le dépôt de la première couche sacrificielle 13, selon un procédé appelé « gate first ».

Selon le premier mode de réalisation de la présente invention, un dispositif CFET comprenant des transistors GAA T1, T2 superposés, à grille 50 commune, et présentant des contacts de source 60Sa, 60Sb et de drain 60Da, 60Db isolés entre eux par les couches diélectriques 31, 35, est réalisé.

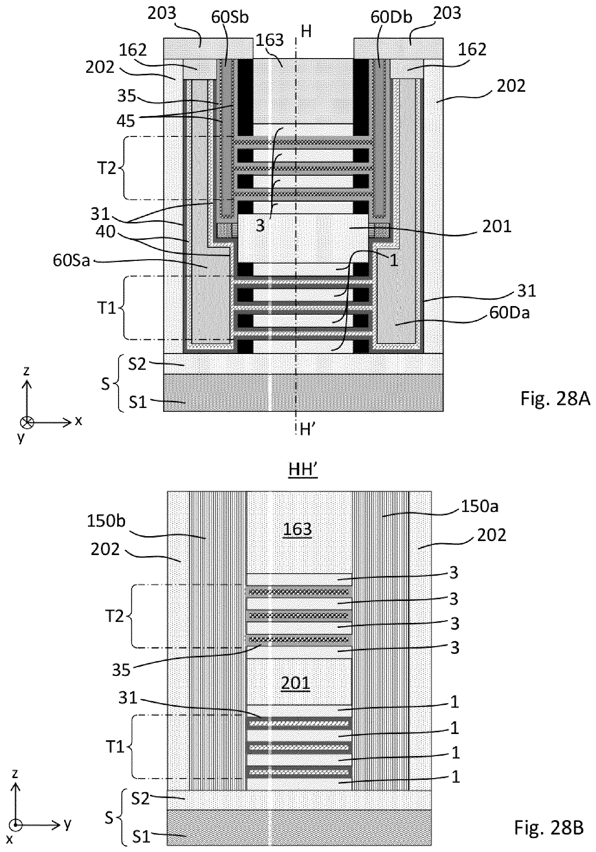

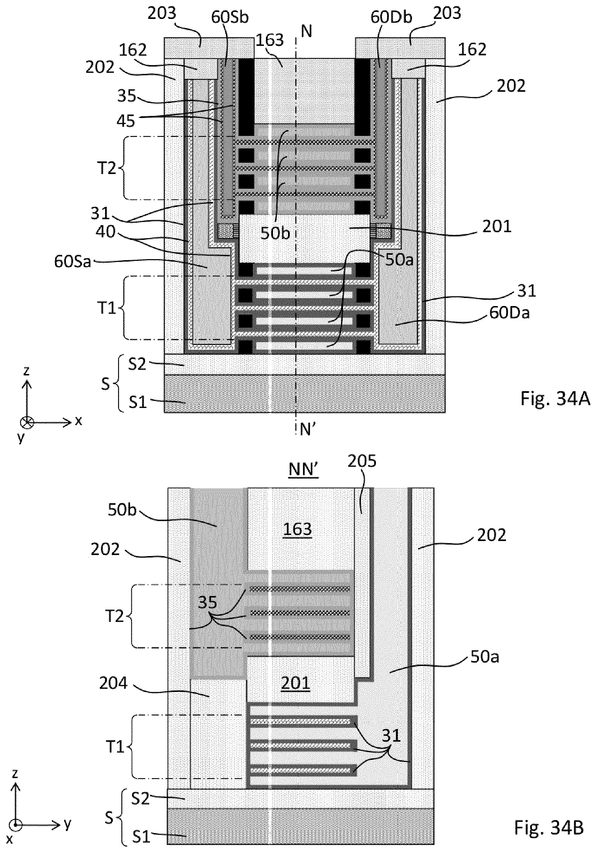

Les figures 28A, 28B à 34A, 34B illustrent schématiquement un deuxième mode de réalisation du procédé de fabrication CFET à transistors GAA ayant des grilles distinctes pour chaque transistor T1, T2. Les figures nA (n=28...34) correspondent à des premières coupes transverses selon un plan xz illustrant chacune une étape différente du procédé de fabrication. Les figures nB (n=28...34) correspondent à des deuxièmes coupes transverses selon un plan yz illustrant chacune la même étape que la figure nA correspondante.

Selon le deuxième mode de réalisation, comme illustré aux figures 28A, 28B, la grille sacrificielle est ici typiquement séparée en deux parties 150a, 150b distinctes. Cette séparation peut être effectuée par l'intermédiaire d'un masque dur 163. En particulier, avant formation de la grille sacrificielle 150 sur les motifs 101M, le masque dur 163 est préalablement formé sur les motifs 101M. Après dépôt de la grille sacrificielle, une étape de polissage mécano-chimique avec arrêt sur le masque dur 163 permet de former deux parties 150a, 150b distinctes de la grille sacrificielle. La première partie 150a de grille sacrificielle s'étend sur un premier côté du motif 101M. La deuxième partie 150b de grille sacrificielle s'étend sur un deuxième côté du motif 101M. Dans la suite ces deux parties 150a, 150b distinctes sont retirées successivement pour être remplacées par des première et deuxième grilles fonctionnelles.

Le masque 203 est formé de sorte à protéger les premiers contacts de source et de drain 60Sa, 60Da et les deuxièmes contacts de source et de drain 60Sb, 60Db, comme précédemment.

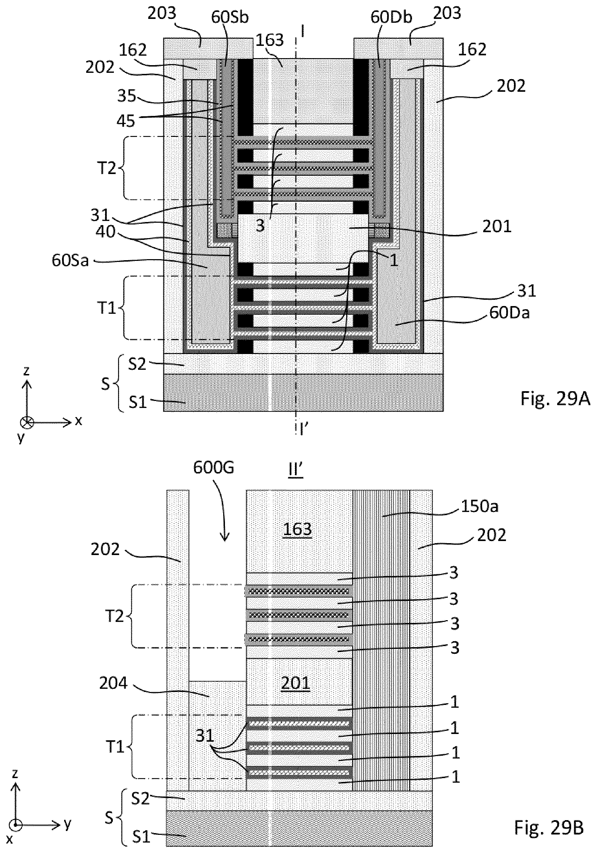

Comme illustré aux figures 29A, 29B, la deuxième partie 150b de grille sacrificielle est d'abord retirée de sorte à former une troisième ouverture 600G exposant des flancs des troisièmes couches 3 du deuxième empilement E2, sur un deuxième côté du motif 101M. Une deuxième portion d'isolation 204, par exemple à base de SiO2, est ensuite formée au fond de la troisième ouverture 600G, au niveau de l'empilement E1. Seuls les flancs des troisièmes couches 3 du deuxième empilement E2 sont ici exposés au travers de l'ouverture 600G.

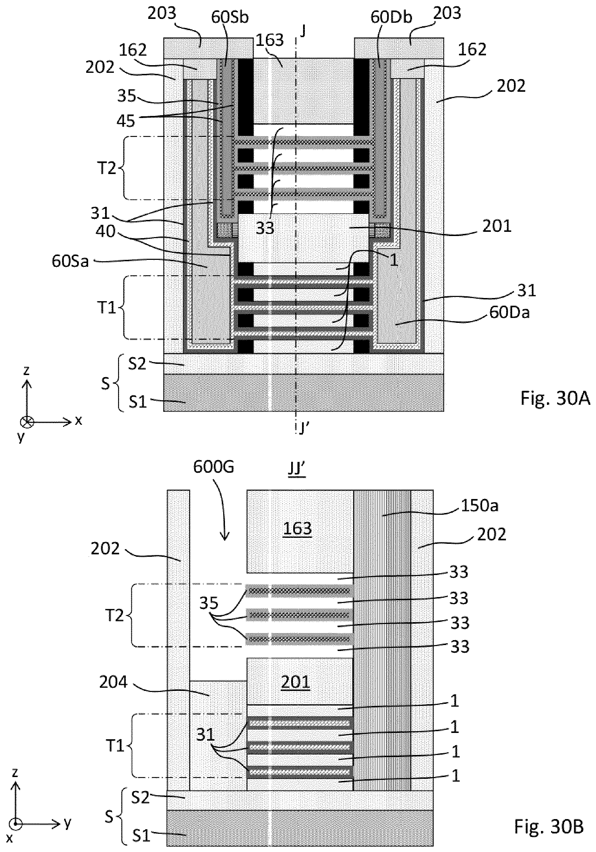

Comme illustré aux figures 30A, 30B, les parties centrales des troisièmes couches 3 sont ensuite totalement gravées sélectivement aux espaceurs internes 131, à la couche isolante 201, à la deuxième couche diélectrique 35 à partir de la troisième ouverture 600G. Cette gravure vise à former les troisièmes espaces 33 à la place des parties centrales des troisièmes couches 3 en vue de la réalisation de la deuxième grille du deuxième transistor T2. Cette gravure totale peut être arrêtée au temps, possiblement après un temps de sur-gravure visant à garantir le retrait total du troisième matériau des troisièmes couches 3. Cette gravure totale présente un caractère isotrope et peut être effectuée par voie humide ou par voie sèche, à partir de la troisième ouverture 600G.

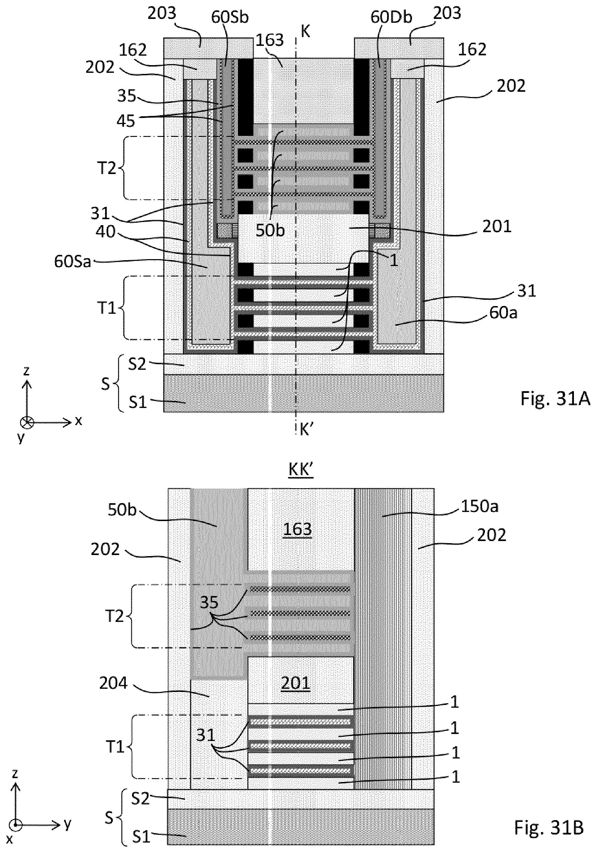

Comme illustré aux figures 31A, 31B, les troisièmes espaces 33 et la troisième ouverture 600G sont ensuite remplis pour former la deuxième grille 50b autour des canaux 41b du deuxième transistor T2. Selon une possibilité, une couche diélectrique additionnelle est déposée dans les troisièmes espaces 33 sur la deuxième couche diélectrique 35, préalablement au remplissage des troisièmes espaces 33 et de la troisième ouverture 600G par une ou plusieurs couches métalliques. Comme précédemment, les couches métalliques peuvent être à base de TiN, W.

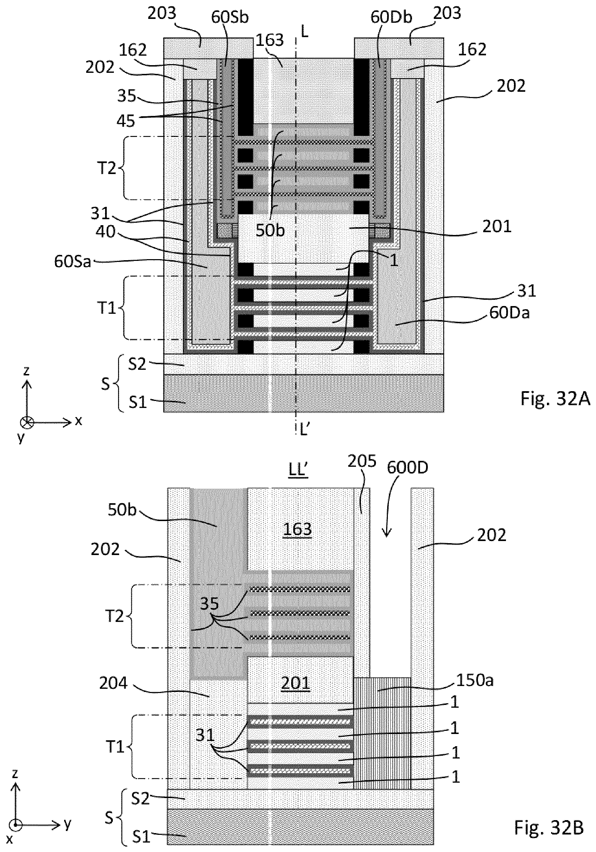

Comme illustré aux figures 32A, 32B, la première partie 150a de grille sacrificielle est de préférence d'abord partiellement retirée de sorte à former une troisième ouverture 600D du premier côté du motif 101M. Lors de cette étape intermédiaire, les flancs du deuxième empilement E2 sur le premier côté du motif 101M sont exposés. Les flancs du premier empilement E1 sur le premier côté du motif 101M sont masqués par la partie restante 150a de grille sacrificielle. Une première portion d'isolation 205, par exemple à base de SiO2, est ensuite formée dans la troisième ouverture 600D, sur la partie restante 150a de grille sacrificielle, pour isoler la future première grille du premier transistor vis-à-vis de la deuxième grille 50b et des canaux 41b du deuxième transistor T2.

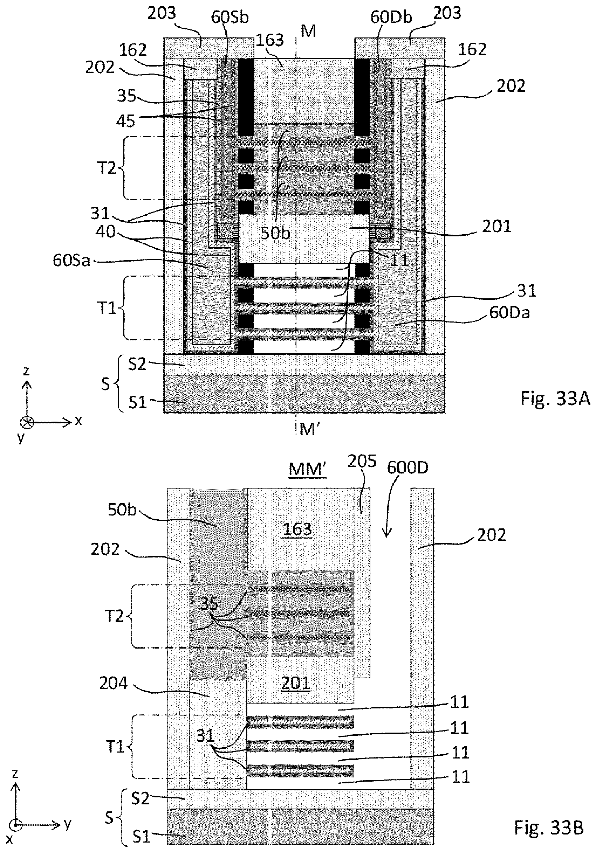

Comme illustré aux figures 33A, 33B, la partie restante 150a de grille sacrificielle est ensuite totalement retirée à travers la troisième ouverture 600D. Les parties centrales des premières couches 1 sont alors gravées sélectivement aux espaceurs internes 101, à la couche isolante 201, à la première couche diélectrique 31, à partir de la troisième ouverture 600D. Cette gravure vise à former des premiers espaces 11 à la place des parties centrales des premières couches 1 en vue de la réalisation de la première grille du premier transistor T1. Cette gravure totale peut être arrêtée au temps, possiblement après un temps de sur-gravure visant à garantir le retrait total du premier matériau des premières couches 1. Cette gravure totale présente un caractère isotrope et peut être effectuée par voie humide ou par voie sèche, à partir de la troisième ouverture 600D.

Comme illustré aux figures 34A, 34B, les premiers espaces 11 et la troisième ouverture 600D sont ensuite remplis pour former la première grille 50a autour des canaux 41a du premier transistor T1. Selon une possibilité, une couche diélectrique additionnelle est déposée dans les premiers espaces 11 sur la première couche diélectrique 31, préalablement au remplissage des premiers espaces 11 et de la troisième ouverture 600D par une ou plusieurs couches métalliques. Comme précédemment, les couches métalliques peuvent être à base de TiN, W.

Selon ce deuxième mode de réalisation, un dispositif CFET comprenant des transistors GAA T1, T2 superposés, à grilles indépendantes 50a, 50b, et présentant des contacts de source 60Sa, 60Sb et de drain 60Da, 60Db isolés entre eux par les couches diélectriques 31, 35, est réalisé. Les grilles indépendantes 50a, 50b sont ici électriquement indépendantes et permettent de contrôler indépendamment le transistor de type P et le transistor de type N superposés.

Les solutions détaillées dans cette invention sont particulièrement efficaces pour fabriquer des dispositifs CFET à transistors GAA superposés. L'invention n'est cependant pas limitée aux modes de réalisations précédemment décrits.

En particulier, le mode de réalisation décrit en référence aux figures 34A et 34B prévoit une isolation du premier contact de source vis-à-vis du deuxième contact de source par la première couche diélectrique et par la deuxième couche diélectrique ainsi qu'une isolation du premier contact de drain vis-à-vis du deuxième contact de drain par ladite première couche diélectrique et par ladite deuxième couche diélectrique. L'invention s'étend également aux modes de réalisation dans lesquels le premier contact de source et le deuxième contact de drain sont distincts et isolés les uns des autres par la première couche diélectrique et par la deuxième couche diélectrique, et dans lesquels le premier contact de drain et le deuxième contact de source sont distincts et isolés les uns des autres par ladite première couche diélectrique et par ladite deuxième couche diélectrique.

## Revendications

1. Dispositif microélectronique comprenant au moins deux transistors superposés (T1, T2) selon une direction principale (z), comprenant :
• Un premier transistor (T1), comprenant :
∘ au moins deux premiers canaux (41a) empilés selon la direction principale (z), chaque canal étant à base d'un premier matériau semiconducteur,
∘ une première source (42a) et un premier drain (43a) à base dudit premier matériau semi-conducteur,
∘ un premier contact de source (60Sa) et un premier contact de drain (60Da) connectés respectivement à ladite première source (42a) et audit premier drain (43a),
∘ une première grille (50, 50a) dite enrobante, entourant totalement au moins l'un des premiers canaux (41a),
∘ une première couche diélectrique (31) séparant chaque premier canal (41a) de la première grille (50, 50a) enrobante,
• Un deuxième transistor (T2), comprenant :
∘ au moins deux deuxièmes canaux (41b) empilés selon la direction principale (z), chaque canal étant à base d'un deuxième matériau semiconducteur,
∘ une deuxième source (42b) et un deuxième drain (43b) à base dudit deuxième matériau semi-conducteur,
∘ un deuxième contact de source (60Sb) et un deuxième contact de drain (60Db) connectés respectivement à ladite deuxième source (42b) et audit deuxième drain (43b),
∘ une deuxième grille (50, 50b) dite enrobante, entourant totalement au moins l'un des deuxièmes canaux (41b),
∘ une deuxième couche diélectrique (35) séparant chaque deuxième canal (41b) de la deuxième grille (50, 50b) enrobante,
le dispositif étant **caractérisé en ce que** le premier contact de source (60Sa) et l'un parmi le deuxième contact de source (60Sb) et le deuxième contact de drain (60Db) sont distincts et isolés les uns des autres par la première couche diélectrique (31) et par la deuxième couche diélectrique (35), et **en ce que** le premier contact de drain (60Da) et l'autre parmi le deuxième contact de source (60Sb) et le deuxième contact de drain (60Db) sont distincts et isolés les uns des autres par ladite première couche diélectrique (31) et par ladite deuxième couche diélectrique (35).

2. Dispositif selon la revendication précédente dans lequel la première couche diélectrique (31) et la deuxième couche diélectrique (35) sont à base du même matériau, formant ainsi localement une couche diélectrique continue entre les premiers et deuxième contacts de source (60Sa, 60Sb) et entre les premiers et deuxième contacts de drain (60Da, 60Db), lorsque la première couche diélectrique (31) et la deuxième couche diélectrique (35) sont en contact direct l'une de l'autre.

3. Dispositif selon l'une quelconque des revendications précédentes dans lequel le premier matériau semiconducteur et le deuxième matériau semiconducteur sont à base d'un matériau bidimensionnel (2D) choisi parmi les dichalcogénures de métaux de transition MX2 avec M pris parmi le molybdène (Mo) ou le tungstène (W), et X pris parmi le soufre (S), le sélénium (Se) ou le tellure (Te).

4. Dispositif selon l'une quelconque des revendications précédentes dans lequel les première et deuxième grilles (50a, 50b) enrobantes forment une même grille (50) commune aux premier et deuxième transistors (T1, T2).

5. Dispositif selon l'une quelconque des revendications 1 à 3, dans lequel les première et deuxième grilles (50a, 50b) enrobantes sont distinctes, la première grille (50a) entourant totalement chaque premier canal (41a) du premier transistor (T1), et la deuxième grille (50b) entourant totalement chaque deuxième canal (41b) du deuxième transistor (T2).

6. Dispositif selon l'une quelconque des revendications précédentes dans lequel le premier matériau semiconducteur présente un premier type de conductivité, par exemple de type N, et le deuxième matériau semiconducteur présente un deuxième type de conductivité différent du premier type de conductivité, par exemple de type P.

7. Procédé de fabrication d'un dispositif microélectronique selon l'une quelconque des revendications précédentes, le procédé comprenant les étapes suivantes :
• Fournir sur un substrat (S) un premier empilement (E1) et un deuxième empilement (E2) superposés selon la direction (z), ledit premier empilement (E1) comprenant une pluralité de premières couches (1) en un premier matériau, alternées avec une pluralité de deuxièmes couches (2) en un deuxième matériau, ledit deuxième empilement (E2) comprenant une pluralité de troisièmes couches (3) en un troisième matériau, alternées avec une pluralité de quatrièmes couches (4) en un quatrième matériau, lesdits premier et deuxième empilements (E1, E2) étant séparés par une couche diélectrique (201),
• Former, dans le premier empilement (E1) et le deuxième empilement (E2) superposés, des premières ouvertures (100) définissant des premiers motifs (101M),
• Former une grille sacrificielle (150) à cheval sur les premiers motifs (101M) et en partie dans les premières ouvertures (100),
• Former dans les premiers motifs (101M) des deuxièmes ouvertures (200) définissant des deuxièmes motifs (102M), de part et d'autre de la grille sacrificielle (150),
• Former une première couche sacrificielle (13) dans les deuxièmes ouvertures (200), sur des flancs des deuxièmes couches (2) du premier empilement (E1),
• Former une deuxième couche sacrificielle (14) sur la première couche sacrificielle (13) et sur des flancs des quatrièmes couches (4) du deuxième empilement (E2), en laissant un espace (400) d'accès à la première couche sacrificielle (13),
• Retirer la première couche sacrificielle (13), à partir de l'espace (400) d'accès, en conservant la deuxième couche sacrificielle (14), de façon à former des premières cavités (400a) débouchant sur les flancs des deuxièmes couches (2) du premier empilement (E1),
• Retirer à partir des premières cavités (400a) le deuxième matériau des deuxièmes couches (2) sélectivement au premier matériau des premières couches (1), de sorte à former des deuxièmes espaces (22),
• Former une première couche diélectrique (31) dans les deuxièmes espaces (22) sur des parties exposées du premier matériau des premières couches (1), et dans les premières cavités (400a) sur des parties exposées de la deuxième couche sacrificielle (14),
• Déposer une couche (40) à base d'un premier matériau semiconducteur dans les deuxièmes espaces (22), sur la première couche diélectrique (31), de sorte à former :
∘ les premiers canaux (41a) du premier transistor (T1) à base du premier matériau semiconducteur, à l'aplomb de la grille sacrificielle (150),
∘ une première source (42a) et un premier drain (43a) du premier transistor (T1) à base du premier matériau semiconducteur, de part et d'autre des premiers canaux (41a) du premier transistor (T1),
• Remplir les premières cavités (400a) par un premier matériau électriquement conducteur pour former des premiers contacts de source et de drain (60Sa, 60Da) du premier transistor (T1),
• Retirer la deuxième couche sacrificielle (14), de façon à former des deuxièmes cavités (400b) débouchant sur les flancs des quatrièmes couches (4) du deuxième empilement (E2),
• Retirer à partir des deuxièmes cavités (400b) le quatrième matériau des quatrièmes couches (4) sélectivement au troisième matériau des troisièmes couches (3), de sorte à former des quatrièmes espaces (44),
• Former une deuxième couche diélectrique (35) dans les quatrièmes espaces (44) sur des parties exposées du troisième matériau des troisièmes couches (3), et dans les deuxièmes cavités (400b) sur la première couche diélectrique (30),
• Déposer une couche (45) à base d'un deuxième matériau semiconducteur dans les quatrièmes espaces (44), sur la deuxième couche diélectrique (35), de sorte à former :
∘ des deuxièmes canaux (41b) du deuxième transistor (T2) à base du deuxième matériau semiconducteur, à l'aplomb de la grille sacrificielle (150),
∘ une deuxième source (42b) et un deuxième drain (43b) du deuxième transistor (T2) à base du deuxième matériau semiconducteur, de part et d'autre des deuxièmes canaux (41b) du deuxième transistor (T2),
• Remplir les deuxièmes cavités (400b) par un deuxième matériau électriquement conducteur pour former des deuxièmes contacts de source et de drain (60Sb, 60Db) du deuxième transistor (T2),
• Retirer la grille sacrificielle de sorte à former des troisièmes ouvertures (600G, 600D),
• Retirer à partir des troisièmes ouvertures (600G, 600D), les premières couches (1) et les troisièmes couches (3), pour former des premiers espaces (11) et des troisièmes espaces (33) respectivement,
• Remplir les premiers et troisièmes espaces (11, 33), pour former respectivement les première et deuxième grilles (50a, 50b) enrobantes des premier et deuxième transistors (T1, T2).

8. Procédé de fabrication selon la revendication précédente, comprenant en outre les étapes suivantes :
• Former des premiers espaceurs (101) entre la première grille (50a) enrobante et les premiers contacts de source et de drain (60Sa, 60Da),
• Former des deuxièmes espaceurs (131) entre la deuxième grille (50b) enrobante et les deuxièmes contacts de source et de drain (60Sb, 60Db).

9. Procédé de fabrication selon la revendication précédente, dans lequel la formation des premiers et deuxièmes espaceurs (101, 131) comprend les étapes suivantes :
• Former de préférence des espaceurs (170) bordant la grille sacrificielle (150) et prenant appui sur les premiers motifs (101M),
• Avant la formation de la première couche sacrificielle (13), retirer partiellement, à partir des deuxièmes ouvertures (200), le premier matériau des premières couches (1) sélectivement au deuxième matériau des deuxièmes couches (2), de sorte à former des premières cavités d'espaceurs (10), de préférence à l'aplomb des espaceurs (170),
• Remplir les premières cavités d'espaceurs (10) par un premier matériau diélectrique pour former les premiers espaceurs (101)
• Avant la formation de la deuxième couche sacrificielle (14), retirer partiellement, à partir des deuxièmes ouvertures (200), le troisième matériau des troisièmes couches (3) sélectivement au quatrième matériau des quatrièmes couches (4), de sorte à former des deuxièmes cavités d'espaceurs (30), de préférence à l'aplomb des espaceurs (170),
• Remplir les deuxièmes cavités d'espaceurs (30) par un deuxième matériau diélectrique pour former les deuxièmes espaceurs (131).

10. Procédé de fabrication selon la revendication précédente, dans lequel le premier matériau des premières couches (1) est identique au troisième matériau des troisièmes couches (3), et dans lequel les premiers et deuxièmes espaceurs (101, 131) sont formés simultanément.

11. Procédé de fabrication selon l'une quelconque des revendications 7 à 10, dans lequel la grille sacrificielle comprend une première partie (150a) et une deuxième partie (150b) distinctes, et dans lequel le retrait de la grille sacrificielle comprend :
• un premier retrait de la première partie (150a) de grille sacrificielle configuré pour former une troisième ouverture (600D) débouchant uniquement sur des flancs des premières couches (1), d'un premier côté seulement du premier motif (101M), suivi d'un retrait des premières couches (1) à partir de ladite troisième ouverture (600D) pour former les premiers espaces (11), et un remplissage desdits premiers espaces (11) pour former la première grille (50a) enrobante du premier transistor (T1), et
• un deuxième retrait de la deuxième partie (150b) de grille sacrificielle configuré pour former une troisième ouverture (600G) débouchant uniquement sur des flancs des troisièmes couches (3), d'un deuxième côté seulement du premier motif (101M), suivi d'un retrait des troisièmes couches (3) à partir de ladite troisième ouverture (600G) pour former les troisièmes espaces (33), et un remplissage desdits troisièmes espaces (33) pour former la deuxième grille (50b) enrobante du deuxième transistor (T2).

12. Procédé de fabrication selon la revendication précédente dans lequel le premier retrait comprend une formation d'une première portion d'isolation (205) sur des flancs du premier empilement (E2) au niveau du premier côté du premier motif (101M), avant remplissage des premiers espaces (11) pour former la première grille (50a) enrobante.

13. Procédé de fabrication selon l'une quelconque des revendications 11 à 12 dans lequel le deuxième retrait comprend une formation d'une deuxième portion d'isolation (204) sur des flancs du premier empilement (E1) au niveau du deuxième côté du premier motif (101M), avant remplissage des troisièmes espaces (33) pour former la deuxième grille (50b) enrobante.

14. Procédé de fabrication selon l'une quelconque des revendications 11 à 13, dans lequel la deuxième grille (50b) enrobante est formée avant la première grille (50a) enrobante.

15. Procédé de fabrication selon l'une quelconque des revendications 11 à 14 comprenant, avant le retrait de la grille sacrificielle, une séparation de la grille sacrificielle en une première partie (150a) et une deuxième partie (150b) distinctes, lesdites première et deuxième parties (150a, 150b) de grille sacrificielle s'étendant respectivement sur les premier et deuxième côtés du premier motif (101M), le premier retrait étant effectué sur la première partie (150a) de grille et le deuxième retrait étant effectué sur la deuxième partie (150b) de grille.

## Patentansprüche

1. Mikroelektronische Vorrichtung, die mindestens zwei Transistoren (T1, T2) umfasst, die entlang einer Hauptrichtung (z) überlagert sind, die Folgendes umfasst:
• einen ersten Transistor (T1), der Folgendes umfasst:
∘ mindestens zwei erste Kanäle (41a), die entlang der Hauptrichtung (z) gestapelt sind, wobei jeder Kanal auf einem ersten Halbleitermaterial basiert;
∘ eine erste Source (42a) und einen ersten Drain (43a) basierend auf dem ersten Halbleitermaterial,
∘ einen ersten Source-Kontakt (60Sa) und einen ersten Drain-Kontakt (60Da), die jeweils mit der ersten Source (42a) und dem ersten Drain (43a verbunden sind,
∘ ein erstes Gate (50, 50a), umhüllend genannt, das mindestens einen der ersten Kanäle (41a) vollständig umgibt,
∘ eine erste dielektrische Schicht (31), die jeden ersten Kanal (41a) von dem ersten umhüllenden Gate (50, 50a trennt,
• einen zweiten Transistor (T2), der Folgendes umfasst:
∘ mindestens zwei zweite Kanäle (41b), die entlang der Hauptrichtung (z) gestapelt sind, wobei jeder Kanal auf einem zweiten Halbleitermaterial basiert;
∘ eine zweite Source (42a) und einen zweiten Drain (43a) basierend auf dem zweiten Halbleitermaterial,
∘ einen zweiten Source-Kontakt (60Sb) und einen zweiten Kontakt-Drain (60Db), die jeweils mit der zweiten Source (42b) und dem zweiten Drain (43b) verbunden sind,
∘ ein zweites Gate (50, 50b), umhüllend genannt, das mindestens einen der zweiten Kanäle (41a) vollständig umgibt,
∘ eine zweite dielektrische Schicht (35), die jeden zweiten Kanal (41b) des zweiten umhüllenden Gates (50, 50b) trennt,
Vorrichtung **dadurch gekennzeichnet, dass** der erste Source-Kontakt (60Sa) und einer des zweiten Source-Kontakts (60Sb) und des zweiten Drain-Kontakts (60Db) getrennt und voneinander durch die erste dielektrische Schicht (31) und durch die zweite dielektrische Schicht (35) getrennt sind, und dass der erste Drain-Kontakt (60Da) und der andere des zweiten Source-Kontakts (60Sb) und des zweiten Drain-Kontakts (60Db) getrennt und voneinander durch die erste dielektrische Schicht 31) und durch die zweite dielektrische Schicht (35) isoliert sind.

2. Vorrichtung nach dem vorstehenden Anspruch, wobei die erste dielektrische Schicht (31) und die zweite dielektrische Schicht (35) auf demselben Material basieren, daher lokal eine kontinuierliche dielektrische Schicht zwischen dem ersten und dem zweiten Source-Kontakt (60Sa, 60Sb) und zwischen dem ersten und dem zweiten Drain-Kontakt (60DA, 60Db) bilden, wenn die erste dielektrische Schicht (31) und die zweite dielektrische Schicht (35) miteinander in direktem Kontakt stehen.

3. Verfahren nach einem der vorstehenden Ansprüche, wobei das erste Halbleitermaterial und das zweite Halbleitermaterial auf einem zweidimensionalen Material (2D-Material) basieren, das aus den Übergangsmetall-Dichalkogeniden MX2 ausgewählt ist, wobei M aus Molybdän (Mo) oder Wolfram (W) ausgewählt ist und X aus Schwefel (S), Selen (Se) oder Tellur (Te) ausgewählt ist.

4. Vorrichtung nach einem der vorstehenden Ansprüche, wobei das erste und das zweite umhüllende Gate (50a, 50b) dasselbe Gate (50) bilden, das dem ersten und dem zweiten Transistor (T1, T2) gemeinsam ist.

5. Vorrichtung nach einem der Ansprüche 1 bis 3, wobei das erste und das zweite umhüllende Gate (50a, 50b) getrennt sind, wobei das erste Gate (50a) jeden ersten Kanal (41a) des ersten Transistors (T1) vollständig umgibt und das zweite Gate (50b) jeden zweiten Kanal (41b) des zweiten Transistors (T2) vollständig umgibt.

6. Vorrichtung nach einem der vorstehenden Ansprüche, wobei das erste Halbleitermaterial einen ersten Leitfähigkeitstyp aufweist, zum Beispiel N, und das zweite Halbleitermaterial einen zweiten Leitfähigkeitstyp, der sich von dem ersten Leitfähigkeitstyp unterscheidet, aufweist, beispielsweise P.

7. Herstellungsverfahren einer mikroelektronischen Vorrichtung nach einem der vorstehenden Ansprüche, wobei das Verfahren die folgenden Schritte umfasst:
• Bereitstellen auf einem Substrat (S) einer ersten Stapelung (E1) und einer zweiten Stapelung (E2), die entlang der Richtung (z) überlagert sind, wobei die erste Stapelung (E1) eine Vielzahl erster Schichten (1) aus einem ersten Material umfasst, die mit einer Vielzahl zweiter Schichten ( 2) aus einem zweiten Material abwechselt, wobei die zweite Stapelung (E2) eine Vielzahl dritter Schichten (3) aus einem dritten Material umfasst, die mit einer Vielzahl vierter Schichten (4) aus einem vierten Material abwechselt, wobei die erste und die zweite Stapelung (E1, E2) durch eine dielektrische Schicht (201) getrennt sind,
• Bilden in der ersten Stapelung (E1) und der zweiten überlagerten Stapelung (E2) erster Öffnungen (100), die erste Strukturen (101M) definieren,
• Bilden eines Opfer-Gates (150), das rittlings auf den ersten Strukturen (101M ) und zum Teil in den ersten Öffnungen (100) liegt,
• Bilden in den ersten Strukturen (101M) zweiter Öffnungen (200), die zweite Strukturen (102M) definieren, zu beiden Seiten des Opfergitters (150),
• Bilden einer ersten Opferschicht (13) in den zweiten Öffnungen (200) auf Flanken der zweiten Schichten (2) der ersten Stapelung (E1),
• Bilden einer zweiten Opferschicht (14) auf der ersten Opferschicht (13) und auf Flanken der vierten Schichten (4) der zweiten Stapelung (E2), wobei ein Zugangsraum (400) zu der ersten Opferschicht (13) belassen wird,
• Entfernen der ersten Opferschicht (13) ausgehend von dem Zugangsraum (400) und Beibehalten der zweiten Opferschicht (14) derart, dass erste Hohlräume (400a) gebildet werden, die auf den Flanken der zweiten Schichten (2) der ersten Stapelung (E1) münden,
• Entfernen ausgehend von den ersten Hohlräumen (400a) des zweiten Materials der zweiten Schichten (2) selektiv zu dem ersten Material der ersten Schichten (1) derart, dass zweite Räume (22) gebildet werden,
• Bilden einer ersten dielektrischen Schicht (31) in den zweiten Räumen (22) auf freigelegten Teilen des ersten Materials der ersten Schichten (1) und in den ersten Hohlräumen (400a) auf freigelegten Teilen der zweiten Opferschicht (14),
• Abscheiden einer Schicht (40) basierend auf einem ersten Halbleitermaterial in den zweiten Räumen (22) auf der ersten dielektrischen Schicht (31) derart, dass Folgendes gebildet wird:
∘ erste Kanäle (41a) des ersten Transistors (T1) basierend auf dem Halbleitermaterial, senkrecht zu dem Opfer-Gate (150),
∘ eine erste Source (42a) und erster Drain (43a) des ersten Transistors (T1) basierend auf dem ersten Halbleitermaterials zu beiden Seiten der ersten Kanäle (41a) des ersten Transistors (T1),
• Füllen der ersten Hohlräume (400a) durch ein erstes elektrisch leitfähiges Material, um erste Source- und Drain-Kontakte (60Sa, 60Da) des ersten Transistors (T1) zu bilden,
• Entfernen der zweiten Opferschicht (14) derart, dass zweite Hohlräume (400b) gebildet werden, die auf den Flanken der vierten Schichten (4) der zweiten Stapelung (E2) münden,
• Entfernen ausgehend von den zweiten Hohlräumen (400b) des Materials der vierten Schichten (4) selektiv zu dem dritten Material der dritten Schichten (3) derart, dass vierte Räume (44) gebildet werden,
• Bilden einer zweiten dielektrischen Schicht (35) in den vierten Räumen (44) auf freigelegten Teilen des dritten Materials der dritten Schichten (3) und in den zweiten Hohlräumen (400b) auf der ersten dielektrischen Schicht (30),
• Abscheiden einer Schicht (45) basierend auf einem zweiten Halbleitermaterial in den vierten Räumen (44) auf der zweiten dielektrischen Schicht (35) derart, dass Folgendes gebildet wird:
∘ zweite Kanäle (41b) des zweiten Transistors (T2) basierend auf dem zweiten Halbleitermaterial, senkrecht zu dem Opfer-Gate (150),
∘ eine zweite Source (42b) und ein zweiter Drain (43b) des ersten Transistors (T2) basierend auf dem zweiten Halbleitermaterial zu beiden Seiten der zweiten Kanäle (41b) des zweiten Transistors (T2),
• Füllen der zweiten Hohlräume (400b) durch ein zweites elektrisch leitfähiges Material, um zweite Source- und Drain-Kontakte (60Sb, 60Db) des zweiten Transistors (T2) zu bilden,
• Entfernen des Opfer-Gates derart, dass dritte Öffnungen (600G, 600D) gebildet werden,
• Entfernen ausgehend von den dritten Öffnungen (600G, 600D) der ersten Schichten (1) und der dritten Schichten (3), um erste Räume (11) bzw. dritte Räume (33) zu bilden,
• Füllen der ersten und der dritten Räume (11, 33), um jeweils das erste und das zweite umhüllende Gate (50a, 50b) des ersten und des zweiten Transistors (T1, T2) zu bilden.

8. Herstellungsverfahren nach dem vorstehenden Anspruch, das außerdem die folgenden Schritte umfasst:
• Bilden der ersten Abstandhalter (101) zwischen dem ersten umhüllenden Gate (50a) und den ersten Source- und Drain-Kontakten (60Sa, 60Da),
• Bilden der zweiten Abstandhalter (131) zwischen dem zweiten umhüllenden Gate (50b) und den zweiten Source- und Drain-Kontakten (60Sb, 60Db)

9. Herstellungsverfahren nach dem vorstehenden Anspruch, wobei das Bilden der ersten und zweiten Abstandhalter (101, 131) die folgenden Schritte umfasst:
• Bilden bevorzugt der Abstandhalter (170), die das Opfer-Gate (150) abgrenzen und auf den ersten Strukturen (101M) aufliegen,
• vor dem Bilden der ersten Opferschicht (13) teilweises Entfernen ausgehend von den zweiten Öffnungen (200) des ersten Materials der ersten Schichten (1) selektiv zu dem zweiten Material der zweiten Schichten (2) derart, dass erste Hohlräume von Abstandhaltern (10) bevorzugt senkrecht zu den Abstandhaltern (170) gebildet werden,
• Füllen der ersten Hohlräume von Abstandhaltern (10) mit einem ersten dielektrischen Material, um erste interne Abstandhalter (101) zu bilden,
• Vor dem Bilden der zweiten Opferschicht (14) teilweises Entfernen ausgehend von den zweiten Öffnungen (200) des dritten Materials der dritten Schichten (3) selektiv zu dem vierten Material der vierten Schichten (4) derart, dass zweite Hohlräume von Abstandhaltern (30) bevorzugt senkrecht zu den Abstandhaltern (170 gebildet werden,
• Füllen der zweiten Hohlräume von Abstandhaltern (30) mit einem zweiten dielektrischen Material, um die zweiten Abstandhalter (131) zu bilden.

10. Herstellungsverfahren nach dem vorstehenden Anspruch, wobei das erste Material der ersten Schichten (1) mit dem dritten Material der dritten Schichten (3) identisch ist, und wobei die ersten und die zweiten Abstandhalter (101, 131) gleichzeitig gebildet werden.

11. Herstellungsverfahren nach einem der Ansprüche 7 bis 10, wobei das Opfer-Gate einen getrennten ersten (150a) und zweiten Teil (150b) umfasst und wobei das Entfernen des Opfer-Gates Folgendes umfasst:
• ein erstes Entfernen des ersten Teils (150a) von dem Opfer-Gate, der dazu konfiguriert ist, eine dritte Öffnung (600D) zu bilden, die lediglich auf Flanken der ersten Schichten (1) auf nur einer ersten Seite der ersten Struktur (101M) mündet, gefolgt von einem Entfernen der ersten Schichten (1) ausgehend von der dritten Öffnung (600D), um erste Räume (11) zu bilden, und ein Füllen der ersten Räume (11), um das erste umhüllende Gate (50a) des ersten Transistors (T1) zu bilden und
• ein Entfernen des zweiten Teils (150a) von dem Opfer-Gate, der dazu konfiguriert ist, eine dritte Öffnung (600G) zu bilden, die lediglich auf Flanken der dritten Schichten (3) auf nur einer zweiten Seite der ersten Struktur (101M) mündet, gefolgt von einem Entfernen der dritten Schichten (3) ausgehend von der dritten Öffnung (600G), um dritte Räume (33) zu bilden, und ein Füllen der dritten Räume (33), um das zweite umhüllende Gate (50a) des zweiten Transistors (T2) zu bilden.

12. Herstellungsverfahren nach dem vorstehenden Anspruch, wobei das erste Entfernen ein Bilden eines ersten Isolierabschnitts (205) auf Flanken der ersten Stapelung (E2) auf der Ebene der ersten Seite der ersten Struktur (101M) vor dem Füllen der ersten Räume (11) umfasst, um das erste umhüllende Gate (50a) zu bilden.

13. Herstellungsverfahren nach einem der Ansprüche 11 bis 12, wobei das zweite Entfernen ein Bilden eines zweiten Isolierabschnitts (204) auf Flanken der ersten Stapelung (E1) auf der Ebene der zweiten Seite der ersten Struktur (101M) vor dem Füllen der dritten Räume (33) umfasst, um das zweite umhüllende Gate (50b) zu bilden.

14. Herstellungsverfahren nach einem der Ansprüche 11 bis 13, wobei das zweite umhüllende Gate (50b) vor dem ersten umhüllenden Gate (50a) gebildet wird.

15. Herstellungsverfahren nach einem der Ansprüche 11 bis 14, das vor dem Entfernen des Opfer-Gates eine Trennung des Opfer-Gates in einen getrennten ersten (150a) und zweiten Teil (150b) umfasst, wobei sich der erste und der zweite Opfer-Gate-Teil (150a, 150b) des Opfer-Gates jeweils auf der ersten und der zweiten Seite der ersten Struktur (101M) erstrecken, wobei das erste Entfernen auf dem ersten Gate-Teil (150a) erfolgt und das zweite Entfernen auf dem zweiten Garde-Teil (150b) erfolgt.

## Claims

1. Microelectronic device comprising at least two superposed transistors (T1, T2) along a main direction (z), comprising:
• A first transistor (T1), comprising:
∘ at least two first channels (41a) stacked along the main direction (z), each channel being with the basis of a first semiconductor material,
∘ a first source (42a) and a first drain (43a) with the basis of said first semiconductor material,
∘ a first source contact (60Sa) and a first drain contact (60Da) connected respectively to said first source (42a) and to said first drain (43a),
∘ a first so-called gate-all-around (50, 50a), totally surrounding at least one of the first channels (41a),
∘a first gate dielectric layer (31) separating each first channel (41a) from the first gate-all-around (50, 50a),
• A second transistor (T2), comprising:
∘ at least two second channels (41b) stacked along the main direction (z), each channel being with the basis of a second semiconductor material,
∘ a second source (42b) and a second drain (43b) with the basis of said second semiconductor material,
∘ a second source contact (60Sb) and a second drain contact (60Db) connected respectively to said second source (42b) and to said second drain (43b),
∘ a second so-called gate-all-around (50, 50b), totally surrounding at least one of the second channels (41b),
∘ a second gate dielectric layer (35) separating each second channel (41b) of the second gate-all-around (50, 50b),
the device being **characterised in that** the first source contact (60Sa) and one from among the second source contact (60Sb) and the second drain contact (60Db) are distinct and isolated from one another by the first gate dielectric layer (31) and by the second gate dielectric layer (35), and **in that** the first drain contact (60Da) and the other from among the second source contact (60Sb) and the second drain contact (60Db) are distinct and isolated from one another by said first gate dielectric layer (31) and by said second gate dielectric layer (35).

2. Device according to the preceding claim, wherein the first dielectric layer (31) and the second dielectric layer (35) are with the basis of the same material, thus locally forming a continuous dielectric layer between the first and second source contacts (60Sa, 60Sb) and between the first and second drain contacts (60Da, 60Db), when the first dielectric layer (31) and the second dielectric layer (35) are in direct contact with one another.

3. Device according to any one of the preceding claims, wherein the first semiconductor material and the second semiconductor material are with the basis of a two-dimensional (2D) material chosen from among MX2 transition metal dichalcogenides with M taken from among molybdenum (Mo) or tungsten (W), and X taken from among sulphur (S), selenium (Se) or tellurium (Te).

4. Device according to any one of the preceding claims, wherein the first and second gates-all-around (50a, 50b) form one same gate (50) common to the first and second transistors (T1, T2).

5. Device according to any one of claims 1 to 3, wherein the first and second gates-all-around (50a, 50b) are distinct, the first gate (50a) totally surrounding each first channel (41a) of the first transistor (T1), and the second gate (50b) totally surrounding each second channel (41b) of the second transistor (T2).

6. Device according to any one of the preceding claims, wherein the first semiconductor material has a first type of conductivity, for example, of the N-type, and the second semiconductor material has a second type of conductivity different from the first type of conductivity, for example, of the P-type.

7. Method for manufacturing a microelectronic device according to any one of the preceding claims, the method comprising the following steps:
• Providing, on a substrate (S), a first stack (E1) and a second stack (E2) superposed along the direction (z), said first stack (E1) comprising a plurality of first layers (1) made of a first material, alternated with a plurality of second layers (2) made of a second material, said second stack (E2) comprising a plurality of third layers (3) made of a third material, alternated with a plurality of fourth layers (4) made of a fourth material, said first and second stacks (E1, E2) being separated by a dielectric layer (201),
• Forming, in the superposed first stack (E1) and the second stack (E2), first openings (100) defining first patterns (101M),
• Forming a sacrificial gate (150) mounted on the first patterns (101M) and partially in the first openings (100),
• Forming, in the first patterns (101M), second openings (200) defining second patterns (102M), on either side of the sacrificial gate (150),
• Forming a first sacrificial layer (13) in the second openings (200), on flanks of the second layers (2) of the first stack (E1),
• Forming a second sacrificial layer (14) on the first sacrificial layer (13) and on flanks of the fourth layers (4) of the second stack (E2), by leaving an access space (400) to the first sacrificial layer (13),
• Removing the first sacrificial layer (13), from the access space (400), by preserving the second sacrificial layer (14), so as to form first cavities (400a) opening onto the flanks of the second layers (2) of the first stack (E1),
• Removing from the first cavities (400a), the second material from the second layers (2) selectively at the first material of the first layers (1), so as to form second spaces (22),
• Forming a first dielectric layer (31) in the second spaces (22) on exposed parts of the first material of the first layers (1), and in the first cavities (400a) on exposed parts of the second sacrificial layer (14),
• Depositing a layer (40) with the basis of a first semiconductor material in the second spaces (22), on the first dielectric layer (31), so as to form:
∘ the first channels (41a) of the first transistor (T1) with the basis of the first semiconductor material, in vertical alignment with the sacrificial gate (150),
∘ a first source (42a) and a first drain (43a) of the first transistor (T1) with the basis of the first semiconductor material, on either side of the first channels (41a) of the first transistor (T1),
• Filling the first cavities (400a) with a first electrically conductive material to form first source and drain contacts (60Sa, 60Da) of the first transistor (T1),
• Removing the second sacrificial layer (14), so as to form second cavities (400b) opening onto the flanks of the fourth layers (4) of the second stack (E2),
• Removing from the second cavities (400b), the fourth material from the fourth layers (4) selectively at the third material from the third layers (3), so as to form fourth spaces (44),
• Forming a second dielectric layer (35) in the fourth spaces (44) on exposed parts of the third material of the third layers (3), and in the second cavities (400b) on the first dielectric layer (30),
• Depositing a layer (45) with the basis of a second semiconductor material in the fourth spaces (44), on the second dielectric layer (35), so as to form:
∘ second channels (41b) of the second transistor (T2) with the basis of the second semiconductor material, in vertical alignment with the sacrificial gate (150),
∘ a second source (42b) and a second drain (43b) of the second transistor (T2) with the basis of the second semiconductor material, on either side of the second channels (41b) of the second transistor (T2),
• Filling the second cavities (400b) with a second electrically conductive material to form second source and drain contacts (60Sb, 60Db) of the second transistor (T2),
• Removing the sacrificial gate so as to form third openings (600G, 600D),
• Removing from the third openings (600G, 600D), the first layers (1) and the third layers (3), to form first spaces (11) and third spaces (33) respectively,
• Filling the first and third spaces (11, 33), to respectively form the first and second gates-all-around (50a, 50b) of the first and second transistors (T1, T2).

8. Manufacturing method according to the preceding claim, further comprising the following steps:
• Forming first spacers (101) between the first gate-all-around (50a) and the first source and drain contacts (60Sa, 60Da),
• Forming second spacers (131) between the second gate-all-around (50b) and the second source and drain contacts (60Sb, 60Db).

9. Manufacturing method according to the preceding claim, wherein the formation of the first and second spacers (101, 131) comprises the following steps:
• Preferably forming spacers (170) bordering the sacrificial gate (150) and bearing on the first patterns (101M),
• Before the formation of the first sacrificial layer (13), partially removing, from the second openings (200), the first material from the first layers (1) selectively at the second material of the second layers (2), so as to form first spacer cavities (10), preferably in vertical alignment with the spacers (170),
• Filling the first spacer cavities (10) with a first dielectric material to form the first spacers (101),
• Before the formation of the second sacrificial layer (14), partially removing, from the second openings (200), the third material from the third layers (3) selectively at the fourth material of the fourth layers (4), so as to form second spacer cavities (30), preferably in vertical alignment with the spacers (170),
• Filling the second spacer cavities (30) with a second dielectric material to form the second spacers (131).

10. Manufacturing method according to the preceding claim, wherein the first material of the first layers (1) is identical to the third material of the third layers (3), and wherein the first and second spacers (101, 131) are simultaneously formed.

11. Manufacturing method according to any one of claims 7 to 10, wherein the sacrificial gate comprises a distinct first part (150a) and a second part (150b), and wherein the removal of the sacrificial gate comprises:
• a first removal of the first sacrificial gate part (150a) configured to form a third opening (600D) only opening onto flanks of the first layers (1), of a first side only of the first pattern (101M), followed by a removal of the first layers (1) from said third opening (600D) to form the first spaces (11), and a filling of said first spaces (11) to form the first gate-all-around (50a) of the first transistor (T1), and
• a second removal of the second sacrificial gate part (150b) configured to form a third opening (600G) only opening onto flanks of the third layers (3), of a second side only of the first pattern (101M), followed by a removal of the third layers (3) from said third opening (600G) to form the third spaces (33), and a filling of said third spaces (33) to form the second gate-all-around (50b) of the second transistor (T2).

12. Manufacturing method according to the preceding claim, wherein the first removal comprises a formation of a first isolation portion (205) on flanks of the first stack (E2) at the first side of the first pattern (101M), before filling of the first spaces (11) to form the first gate-all-around (50a).

13. Manufacturing method according to any one of claims 11 to 12, wherein the second removal comprises a formation of a second isolation portion (204) on flanks of the first stack (E1) at the second side of the first pattern (101M), before filling of the third spaces (33) to form the second gate-all-around (50b).

14. Manufacturing method according to any one of claims 11 to 13, wherein the second gate-all-around (50b) is formed before the first gate-all-around (50a).

15. Manufacturing method according to any one of claims 11 to 14 comprising, before the removal of the sacrificial gate, a separation of the sacrificial gate into a distinct first part (150a) and a second part (150b), said first and second sacrificial gate parts (150a, 150b) extending respectively over the first and second sides of the first pattern (101M), the first removal being done on the first gate part (150a) and the second removal being done on the second gate part (150b).
